(19) Europäisches Patentamt / European Patent Office / Office européen des brevets

(11) **EP 4 409 058 B1**

(12) **EUROPEAN PATENT SPECIFICATION**


(45) Date of publication and mention of the grant of the patent:
**05.11.2025 Bulletin 2025/45**

(21) Application number: **22797287.4**

(22) Date of filing: **23.09.2022**

(51) International Patent Classification (IPC):
***C25D 3/38** (2006.01)* ***C25D 7/12** (2006.01)*
***C08G 73/02** (2006.01)*

(52) Cooperative Patent Classification (CPC):
**C25D 3/38; C08G 73/0286; C08G 73/0293; C25D 7/12**

(86) International application number:
**PCT/EP2022/076474**

(87) International publication number:
**WO 2023/052254 (06.04.2023 Gazette 2023/14)**


(54) **COMPOSITION FOR COPPER ELECTRODEPOSITION COMPRISING A POLYAMINOAMIDE TYPE LEVELING AGENT**

ZUSAMMENSETZUNG FÜR KUPFERELEKTROABSCHEIDUNG MIT EINEM POLYAMINOAMIDARTIGEN NIVELLIERUNGSMITTEL

COMPOSITION D'ÉLECTRODÉPOSITION DE CUIVRE COMPRENANT UN AGENT DE NIVELLEMENT DE TYPE POLYAMINOAMIDE


(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.10.2021 EP 21200566**

(43) Date of publication of application:
**07.08.2024 Bulletin 2024/32**



(73) Proprietor: **BASF SE**
**67056 Ludwigshafen am Rhein (DE)**

(72) Inventors:
- **ARNOLD, Marco**
**67056 Ludwigshafen (DE)**
- **FLUEGEL, Alexander**
**67056 Ludwigshafen (DE)**
- **KUTTNER, Elisabeth**
**67056 Ludwigshafen (DE)**
- **ENGELHARDT, Nadine**
**67056 Ludwigshafen (DE)**

(74) Representative: **BASF IP Association**
**BASF SE**
**GBI - Z078**
**67056 Ludwigshafen (DE)**



(56) References cited:
**EP-A1- 2 530 102**
**WO-A1-2021/058334**
**US-A1- 2018 051 014**
**US-A1- 2020 185 224**
**US-B2- 10 767 275**
**US-B2- 9 758 885**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



EP 4 409 058 B1

## Description

Background of the Invention

The invention relates to a copper electroplating composition comprising a polyaminoamide type leveling agent, its use and a process for copper electrodeposition.

Bumps are formed on a surface of a wafer having integrated circuits, such as LSIs. Such bumps constitute a part of interconnects of an integrated circuit and serve as terminals for connection to a circuit of an external package substrate (or a circuit substrate). The bumps are generally disposed along a periphery of a semiconductor chip (or die) and are connected to an external circuit by gold wires according to a wire bonding method or by leads according to a TAB method.

With the recent progress toward higher integration and higher density of semiconductor devices, the number of bumps for connection to external circuits is increasing, giving rise to the necessity to form bumps over the entire area of the surface of a semiconductor chip. Further, the need for shorter interconnect spacing has led to the use of a method (flip chip method) which involves flipping a semiconductor chip having a large number of bumps formed on its surface and connecting the bumps directly to a circuit substrate.

Electroplating is widely employed as a method of forming bumps. A process of forming bumps on a surface of a wafer having integrated circuits is one of the most important processes in a final stage of manufacturing of a semiconductor device. It is to be noted in this regard that an integrated circuit is formed on a wafer through many manufacturing processes. Therefore, very high reliability is required for a bump forming process which is performed on a wafer that has passed all the preceding processes. With the progress toward smaller-sized semiconductor chips, the number of bumps for connection to external circuits is increasing and bumps themselves are becoming smaller sized. Accordingly, a need exists to enhance the accuracy of positioning for bonding of a semiconductor chip to a circuit substrate such as a package substrate. In addition, there is a strong demand for no defect being produced in a bonding process in which bumps are melted and solidified.

Generally, copper bumps are formed on a seed layer of a wafer which is electrically connected to integrated circuits. A resist having openings is formed on a seed layer, and copper is deposited by copper electroplating on the exposed surface of the seed layer in the openings to thereby form copper bumps. The seed layer comprises a barrier layer, e.g. composed of titanium, to prevent diffusion of copper into the dielectric. After filling the openings in the resist with copper, the resist is removed, and then the copper bumps are subjected to reflow processing.

The need to fit more functional units into ever-tinier spaces drives the integrated circuit industry to bump processes for package connections. A second driver is to maximize the amount of input/output connections for a given area. With decreasing diameter of and distance between the bumps the connection density can be increased. These arrays are realized with copper bumps or $\mu$-pillars on which a tin or tin alloy solder cap is plated. In order to assure that every bump is getting contacted across a wafer, besides a void-free deposition and reflow, uniform deposition height is needed. In addition, alternative packaging technologies like Fan-Out technologies require redistribution layers (RDL) made of copper. These RDLs require uniform plating at various line spaces as well as on pads with different dimensions.

To achieve this uniform deposition so-called levelers may be used. In literature, a variety of different leveling compounds has been described for other electroplating applications. In most cases, leveling compounds are N-containing and optionally substituted and/or quaternized polymers, such as polyethylene imine, polyglycine, poly(allylamine), polyaniline (sulfonated), polyurea, polyacrylamide, poly(melamine-co-formaldehyde), reaction products of amines with epichlorohydrin, reaction products of an amine, epichlorohydrin, and polyalkylene oxide, reaction products of an amine with a polyepoxide, polyvinylpyridine, polyvinylimidazole, polyvinylpyrrolidone, polyalkoxylated polyamides and polyalkanolamines.

US 2012/292193 A discloses leveling agents comprising polyaminoamides, alkoxylated polyaminoamides, functionalized polyaminoamides, and functionalized and alkoxylated polyaminoamides. US 2014/097092 A discloses aromatic PAAs for use in through silicon via copper electrodeposition application. In WO 2014/072885 polyaminoamides are described which may be obtained by reacting at least one diamine with at least one N,N'-bisacrylamide.

US 6425996 B1 discloses leveling agents comprising the reaction product of polyaminoamides and epihalohydrins, dihalohydrins and 1-halogen-2,3-propanediols, respectively.

US2016/0076160 A1 discloses an electrolytic plating composition useful in filling submicron features of a semiconductor integrated circuit device or through silicon vias which contains a leveler that comprises the reaction product of an aliphatic di(t-amine) with an alkylating agent.

Unpublished international patent application No. PCT/EP2021/057522 discloses a copper electroplating composition comprising a polyaminoamide type leveling agent preparable from a diamine comprising a tertiary and a primary or secondary amino group, a diacid and a coupling agent.

There is still a need in the electronic industry for an acidic copper electroplating bath which leads to bump deposit with a good morphology, particularly a low roughness, in combination with an improved uniformity in height, also called within-die coplanarity (COP).

For alkaline zink or zink alloy, e.g. ZnFeCo alloy, electrodeposition compositions specific cationic polymers are used to enhance brightness and alloy components uniformity. One of these cationic polymers e.g. disclosed in US 5435898 is MIRAPOL AD-1 of formula

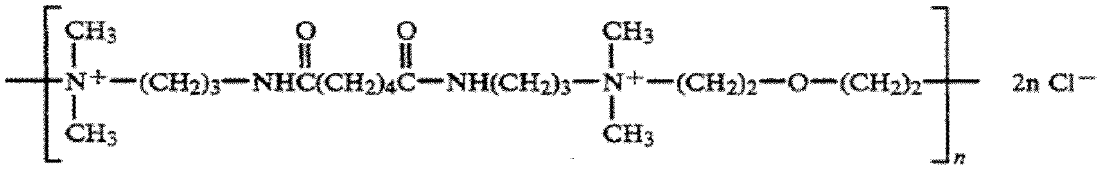

It is an object of the present invention to provide a copper electroplating composition, particularly an acidic copper electroplating composition that provides copper deposits showing a good morphology, particularly a low roughness and which is capable of filling recessed features on the micrometer scale without substantially forming defects, such as but not limited to voids. It is a further object of the present invention to provide a copper electroplating bath that provides a uniform and planar copper deposit, in particular in recessed features of 500 nanometers to 500 micrometers widths such as bumps.

Summary of the Invention

Surprisingly, it has now been found, that the use of particular cationic aminoamide polymers show extraordinary leveling properties in copper bump and RDL electroplating.

Therefore, the present invention provides a composition comprising copper ions, an acid, and at least one polyaminoamide comprising, a group of formula L1

$$[B\text{-}A\text{-}B'\text{-}Z]_n[Y\text{-}Z]_m \qquad (L1)$$

wherein

B, B' are the same or different, preferably the same, and are aminoacid fragments of formula L2a

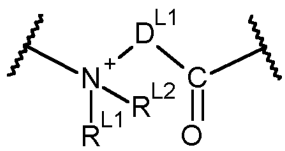

(L2a)

or of Formula L2b

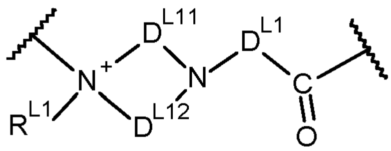

(L2b)

A is a diamine fragment independently selected from formula L3a

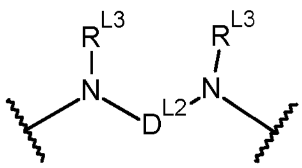

(L3a)

or of Formula L3b

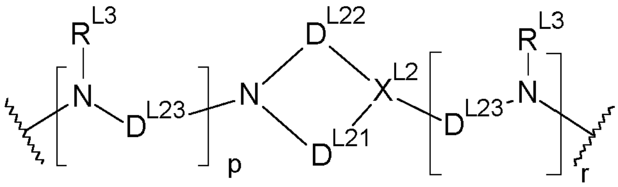

(L3b)

$D^{L1}$ is selected from a divalent group selected from

(a) a $C_1$-$C_{20}$-alkanediyl which may optionally be substituted by an amino group or interrupted by a double bond or an imino group,
(b) an ether or polyether group of formula L2a

$$-(D^{L10}-O-]_o D^{L10}- \qquad (L2c)$$

$D^{L2}$ is a divalent group selected from

(a) a linear, branched or cyclic $C_1$ to $C_{20}$ alkanediyl, which may optionally be interrupted by one ore more $NR^{L10}$, or substituted by one or more, preferably 1 or 2, groups $NR^{L10}R^{L11}$ or $OR^{L10}$, or
(b) $-D^{L13}-Ar^{L13}-D^{L13}-$; or
(c) an ether or polyether group of formula L2c

$$-(D^{L10}-O-]_o D^{L10}- \qquad (L2c)$$

$D^{L10}$ is selected from a linear or branched $C_1$-$C_6$-alkanediyl, preferably ethanediyl or propanediyl;
$D^{L13}$ is selected from a $C_1$-$C_6$-alkanediyl, preferably methanediyl or ethanediyl;
$Ar^{L13}$ is a $C_6$ to $C_{10}$ aromatic moiety, preferably p-phenylene;
$D^{L11}$,$D^{L12}$ are

(a) independently selected from a linear or branched $C_1$ to $C_6$ alkanediyl, or
(b) both, together with the adjacent two N atoms, part of a 5 or 6-membered aromatic heterocyclic ring system;

$D^{L21}$,$D^{L22}$ are

(a) independently selected from a linear or branched $C_1$ to $C_6$ alkanediyl, or
(b) both, together with the adjacent two N atoms, part of a 5 or 6-membered aromatic heterocyclic ring system;

$D^{L23}$ is a $C_1$ to $C_6$ alkanediyl;
$R^{L1}$, $R^{L2}$ are independently selected from a $C_1$ to $C_6$ alkyl;
$R^{L3}$ is selected form H and a $C_1$ to $C_6$ alkyl;
$X^{L2}$ is N or $CR^{L3}$;
Y is a co-monomer fragment;
Z is a divalent coupling fragment of formula L4

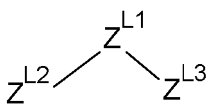

(L4)

$Z^{L1}$ is selected from

(a) a linear or branched $C_1$ to $C_{12}$ alkanediyl, which may be interrupted by one or more O atoms, preferably a $C_1$ to $C_6$ alkanediyl, which may be interrupted by 1 or two O atoms, or
(b) a divalent group $-D^{L11}-Ar^{L11}-D^{L11}-$;

$Z^{L2}$, $Z^{L3}$ are independently selected from a chemical bond and hydroxyethanediyl;
n is an integer of from 1 to 400;
m is 0 or an integer of from 1 to 400;
o is an integer of from 1 to 100; and
p, r are independetly 0 or 1.

The leveling agents according to the present invention are particularly useful for filling of recessed features having aperture sizes of 500 nm to 500 μm, particularly those having aperture sizes of 1 to 200 μm. The leveling agents are particularly useful for depositing copper bumps.

Due to the leveling effect of the leveling agents, surfaces are obtained with an improved coplanarity of the plated copper bumps. The copper deposits show a good morphology, particularly a low roughness. The electroplating composition is capable of filling recessed features on the micrometer scale without substantially forming defects such as but not limited to voids. The electroplating composition ensures uniform plating at various line spaces as well as on pads with different dimensions which makes it particularly useful for RDL applications.

Furthermore, the leveling agents according to the invention lead to reduced impurities, such as but not limited to organics, chloride, sulfur, nitrogen, or other elements. Especially, when solder is directly plated on copper higher organic impurity levels lead to pronounced Kirkendall voiding. These voids lower the reliability of the solder stack and is therefore less preferred.

The additives described herein additionally facilitate high plating rates and allows plating at elevated temperature.

A further advantage of the leveling agents according to the invention is its flexibility with respect to adaption of nitrogen-content, hydrophilicity, charge and charge density, suppressing capabilities which makes it easier to adapt them to the very specific needs of the substrate. In view of the international patent application No. PCT/EP2021/057522 the levelers according to the present invention synthesized from a tertiary aminoacid, a diamine and a coupling agent increase this flexibility even more since completely new combinations of building blocks are accessible.

The invention further relates to the use of the aqueous composition as described herein for depositing copper on a substrate comprising a recessed feature comprising a conductive feature bottom and a dielectric feature side wall, wherein the recessed feature has an aperture size from 500 nm to 500 μm.

The invention further relates to a process for electrodepositing copper on a substrate comprising a recessed feature comprising a conductive feature bottom and a dielectric feature side wall, the process comprising:

(a) contacting a composition as described herein with the substrate, and
(b) applying a current to the substrate for a time sufficient to deposit a copper layer into the recessed feature,

wherein the recessed feature has an aperture size from 500 nm to 500 μm.

## Detailed Description of the Invention

It has been found, that quaternized coupled aminoamide polymers may advantageously be used as leveling agents in copper electroplating of bump structures showing an improved leveling performance. The quaternized coupled aminoamide polymers are also referred to herein as "cationic aminoamide polymers", "coupled aminoamide polymers", "coupled aminoamide", "leveling agent" or "leveler".

As used herein, "accelerator" refers to an organic additive that increases the plating rate of the electroplating bath. The terms "accelerator" and "accelerating agent" are used interchangeably throughout this specification. In literature, sometimes the accelerator component is also named "brightener" or "brightening agent". "Suppressing agent" or "suppressor" refers to an organic compound that decreases the plating rate of the electroplating bath and ensures that the recessed features are voidless filled from the bottom to the top (so called "bottom-up filling"). The terms "suppressors" and "suppressing agents" are used interchangeably throughout this specification. "Leveler" refers to an organic compound that is capable of providing a substantially planar metal deposit over areas with a higher or lower number of recessed features, or different areas across a wafer or die. The terms "leveler", "leveling agent" and "leveling additive" are used interchangeably throughout this specification.

"Aperture size" according to the present invention means the smallest diameter or free distance of a recessed feature before plating. The terms "width", "diameter", "aperture" and "opening" are used herein, depending on the geometry of the feature (trench, via, etc.) synonymously. As used herein, "aspect ratio" means the ratio of the depth to the aperture size of the recessed feature.

As used herein, "chemical bond" means that the respective moiety is not present but that the adjacent moieties are bridged so as to form a direct chemical bond between these adjacent moieties. By way of example, if in a molecule A-B-C the moiety B is a chemical bond then the adjacent moieties A and C together form a group A-C.

The term "$C_x$" means that the respective group comprises x numbers of C atoms. The term "$C_x$ to $C_y$ alkyl" means alkyl with a number x to y of carbon atoms and, unless explicitly specified, includes unsubstituted linear, branched and cyclic alkyl. As used herein, "alkanediyl" refers to a diradical of linear, branched or cyclic alkanes or a combination thereof.

As used herein, "aromatic rings" cover aryl and heteroaryl groups.

Leveling agents according to the invention

Besides copper ions and an acid, the metal electroplating composition comprises at least one polyaminoamide of formula I:

$$[B\text{-}A\text{-}B'\text{-}Z]_n[Y\text{-}Z]_m \qquad (L1)$$

The additive according to Formula L1 is generally obtainable by first reacting a diamine compound ('a') comprising two a primary or secondary amino groups with an aminoacid 'b' in a molar ratio of approx. 1:2 to form an aminoamide compound b-A-b'. In contrast to the compounds disclosed in US 6425996 B1, discrete monomeric compounds are received in this intermediate product.

Afterwards this monomeric aminoamide intermediate compound is reacted with a coupling agent 'z' to connect several aminoamide compounds with each other to form the coupled aminoamide $[A\text{-}B\text{-}A'\text{-}Z]_n$ according to the invention.

By way of example, this reaction scheme illustrates the leveler preparation by starting from 3-Aminopropylamine, N,N-dimethylglycine and epichlorohydrine:

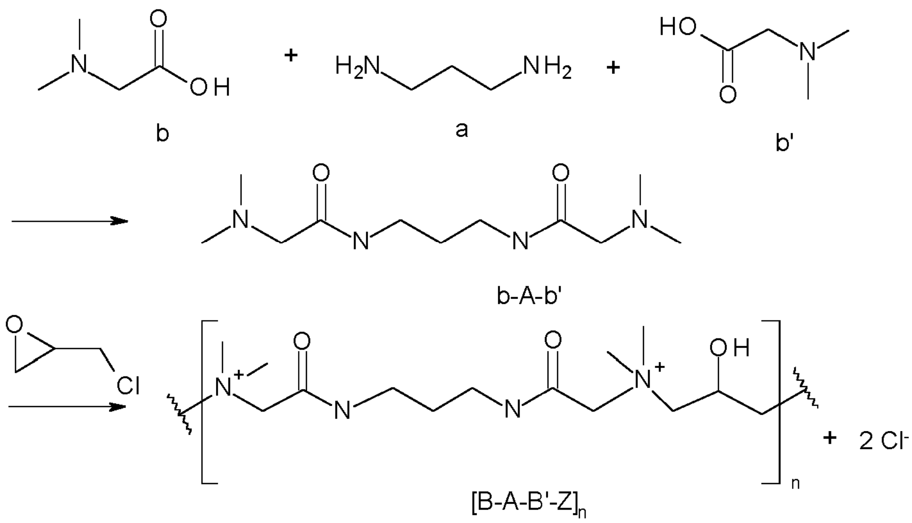
b
a
b'
b-A-b'
+ 2 Cl-
$[B\text{-}A\text{-}B'\text{-}Z]_n$

In a first step discrete aminoamide monomers b-A-b' are prepared, which are then coupled together with the coupling agent z. In this case m is 0.

It is also possible to co-couple further amine co-monomers Y comprising a tertiary amino group and a secondary or tertiary amino group with the aminoamide compound. In this case m is equal to or greater than 1.

The fragments A, B, B', Z and Y are described in the following in more detail.

In a first embodiment the aminoacid compounds b and 'b' form two aminoacid fragments B and B' of formula L2a

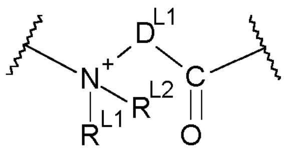
(L2a)

In formula L2a the aminoacid spacer $D^{L1}$ is selected from a divalent group selected from (a) a $C_1$-$C_{20}$-alkanediyl which may optionally be substituted by an amino group or interrupted by a double bond or an imino group, or (b) an ether or polyether group of formula L2a

$$-(D^{L10}\text{-}O\text{-}]_o D^{L10}\text{-} \qquad (L2c)$$

wherein $D^{L10}$ is selected from a $C_1$-$C_6$-alkanediyl, preferably a $C_1$-$C_4$-alkanediyl, most preferably ethanediyl or propanediyl and o is an integer of from 1 to 100, preferably of from 1 to 20, most preferably from 1 to 15. In a particular embodiment o is from 3 to 10, in another embodiment o is from 10 to 20.

In a preferred embodiment $D^{L1}$ is selected from (i) a linear $C_2$ to $C_{10}$ alkanediyl group, which may be unsubstituted or substituted by an amino group, (ii) a $C_2$ to $C_3$ oxyalkylene group, (iii) a cyclic $C_6$ to $C_{12}$ alkanediyl group, or (iv) a divalent

phenyl or pyridyl group.

In another preferred embodiment $D^{L1}$ is selected from ethanediyl, propanediyl, butanediyl, pentanediyl, hexanediyl, heptanediyl, octanediyl, nonanediyl, or decanediyl, which may be unsubstituted or substituted by an amino group. Most preferably $D^{L1}$ is selected from ethane-1,2-diyl, propane-1,3-diyl, butane-1,4-diyl, pentane-1,5-diyl, 5-aminopentane-1,5-diyl, and hexane-1,6-diyl.

In formula L2a, $R^{L1}$ and $R^{L2}$ are independently selected from a $C_1$ to $C_6$ alkyl, preferably methyl, ethyl or propyl. $R^{L3}$ is selected form H and a $C_1$ to $C_6$ alkyl, preferably from H and methyl.

In another embodiment the aminoacid compounds b and 'b' form two aminoacid fragments B and B' of formula L2b

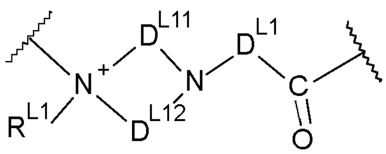

(L2b)

In formula L2b the divalent groups $D^{L11}$ and $D^{L12}$ are either (a) independently selected from a linear or branched $C_1$ to $C_6$ alkanediyl, or (b) both, together with the adjacent two N atoms, part of a 5 or 6-membered aromatic heterocyclic ring system. $D^{L1}$ may be same as defined for formula L2a above. $R^{L1}$ is selected from a $C_1$ to $C_6$ alkyl, preferably methyl, ethyl or propyl.

In a first preferred embodiment of formula L2b $D^{L11}$ and $D^{L12}$ are independently selected from a linear or branched $C_1$ to $C_4$ alkanediyl. Even more preferably $D^{L11}$ and $D^{L12}$ are selected from $(CH_2)_g$, wherein g is an integer from 1 to 6, preferably 1 to 3. Most preferably $D^{L11}$ and $D^{L12}$ are both ethanediyl, or $D^{L11}$ is methanediyl and $D^{L12}$ is propanediyl.

In another preferred embodiment of formula L2b $D^{L11}$ and $D^{L12}$, together with the two adjacent N atoms, form an imidazole ring.

Without limitation, tertiary aminoacids that are particularly useful for the preparation of the levelers according to the invention are N,N-dimethylglycine, 3-(Dimethylamino)propanoic acid, 4-(Dimethylamino)butanoic acid, 5-(dimethylamino)pentanoic acid, 1H-imidazole-1-acetic acid, 1H-imidazole-1-propanoic acid, 1H-imidazole-1-butanoic acid, and an aminoacid of formula L2d

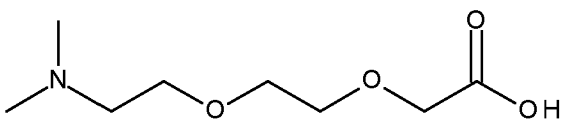

(L2d)

The aminoacids may be used in the form of the free acids or as carboxylic acid derivatives, such as anhydrides, esters, amides or acid halides, in particular chlorides. Preference is given to using the free amino acids.

Since the aminoacid fragments B and B' are positively charged, counterion $Y^{y-}$ are required to neutralize the whole composition, wherein y is a positive integer. Preferably such counter ions may be selected from halide, particularly chloride, methane sulfonate, sulfate or acetate.

The diamine compound 'a' forms a diamine fragment A of formula L3a

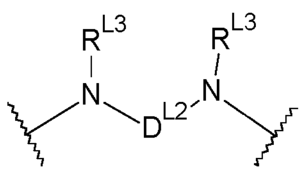

(L3a)

or of Formula L3b

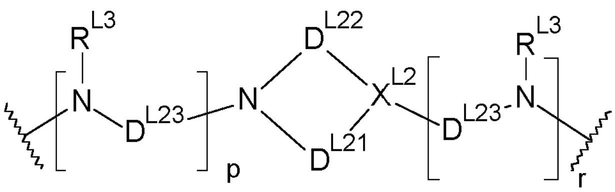

(L3b)

Herein the primary or secondary amine functional groups of both amine compounds are bound to the carbonyl

functionality of the aminoacid fragment, respectively.

In a first embodiment of formula L3a the divalent group $D^{L2}$ is selected from a linear or branched $C_1$ to $C_{20}$ alkanediyl, which may optionally be interrupted by one or more $NR^{L10}$ or S, or substituted by one or more, preferably 1 or 2 groups $NR^{L10}R^{L11}$ or $OR^{L10}$, wherein $R^{L10}$, $R^{L11}$ are independently selected from H and $C_1$-$C_{10}$ alkyl, more preferably from H and $C_1$-$C_4$ alkyl, most preferably from H, methyl or ethyl. In a particularly preferred embodiment $D^{L2}$ is selected from a linear or branched $C_1$ to $C_6$ alkanediyl. Even more preferably $D^{L2}$ is selected from $(CH_2)_g$, wherein g is an integer from 1 to 6, preferably 1 to 3. Most preferably $D^{L2}$ is 1,2-ethanediyl or 1,3-propanediyl.

In a second embodiment of formula L3a the divalent group $D^{L2}$ is selected from $-D^{L11}-Ar^{L13}-D^{L13}$ wherein $D^{L13}$ is selected from a $C_1$-$C_6$-alkanediyl, preferably methanediyl or ethanediyl, and $Ar^{L13}$ is a $C_6$ to $C_{10}$ aromatic moiety, preferably phenylene, most preferably p-phenylene.

In a third embodiment of formula L3a the divalent group $D^{L2}$ is selected from an ether or polyether group of formula L2a

$$-(D^{L10}-O-]_o D^{L10}- \qquad \text{(L2a)}$$

wherein $D^{L10}$ is selected from a $C_1$-$C_6$-alkanediyl, preferably a $C_1$-$C_4$-alkanediyl, most preferably ethanediyl or propanediyl and o is an integer from 1 to 100, preferably from 1 to 50, most preferably from 1 to 15. In a particular embodiment o is an integer from 3 to 10, in another embodiment o is an interger from 10 to 40.

In formula L3b the divalent groups $D^{L21}$ and $D^{L22}$ are (a) independently selected from a linear or branched $C_1$ to $C_6$ alkanediyl, preferably methanediyl, ethanediyl or propanediyl, or (b) $D^{L21}$ and $D^{L22}$ are both, together with the adjacent two N atoms, part of a 5 or 6-membered aromatic heterocyclic ring system. $D^{L23}$ may be a $C_1$ to $C_6$ alkanediyl, preferably methanediyl, ethandiyl, propanediyl or butanediyl, most prferably methanediyl, ethandiyl, or propanediyl. $R^{L3}$ may be selected form H and a $C_1$ to $C_6$ alkyl, preferably H or methyl, most preferably H. $X^{L2}$ may be N or $CR^{L3}$, preferably N, C-H or C-$CH_3$; p and r may be the same or different and be 0 or 1. If p or r is 1, the respective aminoacid is connected to a primary or secondary amine functional group; if p or r is 0, the respective aminoacid is connected to the secondary amine functional group that is part of the ring system.

In a first preferred embodiment of formula L3b $D^{L21}$ and $D^{L22}$ are independently selected from a linear or branched $C_1$ to $C_4$ alkanediyl. Even more preferably $D^{L21}$ and $D^{L22}$ are selected from $(CH_2)_g$, wherein g is an integer from 1 to 6, preferably 1 to 3. Most preferably $D^{L21}$ and $D^{L22}$ are both ethanediyl, or $D^{L21}$ is methanediyl and $D^{L22}$ is propanediyl.

In a second preferred embodiment of formula L3b $D^{L21}$ and $D^{L22}$, together with the two adjacent N atoms, form an imidazole ring.

Diamines that are particularly useful for the preparation of the levelers according to the invention are propylenediamine, 1,3-diaminopropane, 1,4-diaminobutane, 1,6-diaminohexane, 1,8-diaminooctane, 1,12-diaminododecane, diaminodicyclohexylmethane, isophorondiamine, 3,3'-dimethyl-4,4'-diamino¬dicyclo¬hexyl¬methane, 4,7,10-trioxatridecane-1,13-diamine, Xylenediamine, Poly(propylene glycol) bis(2-aminopropyl ether with an average degree of polymerization of from 1 to 50, preferably 2 to 40, most preferably 1 to 10, and lysine.

As used herein, "average degree of polymerization" means the average number of repeating monomeric units in the polymer.

The coupling agent 'z' forms the coupling fragment Z of formula L4

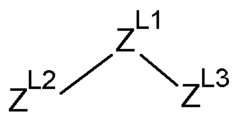

(L4)

wherein

$Z^{L1}$ is selected from

(a) a linear or branched $C_1$ to $C_{12}$ alkanediyl, which may be interrupted by one or more O atoms, preferably a $C_1$ to $C_6$ alkanediyl, which may be interrupted by 1 or two O atoms; or

(b) a divalent group $-D^{L11}-Ar^{L11}-D^{L11}-$;

$Z^{L2}$, $Z^{L3}$ are independently selected from a chemical bond or hydroxyethanediyl.

In a first preferred embodiment $Z^{L1}$ is selected from a $C_1$ to $C_{12}$ alkanediyl, preferably a $C_1$ to $C_4$ alkanediyl, most preferably methanediyl or ethanediyl. In a second preferred embodiment $Z^{L1}$ is selected from an alkylether or polyalkylether group of formula $-(D^{L10}-O-]_o D^{L10}-$, particularly a bis(2-ethanediyl)ether group, wherein $D^{L10}$ is selected from a $C_1$-$C_6$-alkanediyl, preferably a $C_1$-$C_4$-alkanediyl, most preferably ethanediyl or propanediyl and o is an integer of from 1 to

100, preferably of from 1 to 20, most preferably from 1 to 10. In a particular embodiment o is from 1 to 5, in another embodiment o is from 5 to 15. In a third preferred embodiment $Z^{L1}$ is selected from a divalent group $-D^{L11}-Ar^{L11}-D^{L11}-$, particularly a biphenyl group, wherein $D^{L11}$ is selected from a $C_1$-$C_6$-alkanediyl, preferably methanediyl and ethanediyl, and $Ar^{L11}$ is a $C_6$ to $C_{12}$ aromatic moiety, preferably phenylene or biphenylene.

In another preferred embodiment $Z^{L2}$ is selected from a chemical bond and $Z^{L3}$ is selected from hydroxyethanediyl. In yet another preferred embodiment both $Z^{L2}$ and $Z^{L3}$ are selected from a chemical bond.

Such coupling fragments Z are received from coupling agents comprising a leaving group such as but not limited to halogen, particularly Cl or Br, and/or an epoxy group.

Particularly preferred coupling agents 'z' are selected from bis(2-chloroethyl)ether; bis(2-chloro-ethoxy)ethane; epichlorohydrine, 1,ω-dihalo($C_2$-$C_{10}$)alkanes, such as but not limited to 1,3-dichloro propane, 1,4-dichloro butane, 1,5-dichloro pentane, and 1,6-dichlorohexane; bis(2-chloroethyl)ether, di(haloalkyl)aryl groups such as but not limited to xylylene dichloride and 4,4'-bis(bromomethyl)biphenyl. Herein chloride or bromide may be exchanged by other leaving groups, such as but not limited to triflate, tosylate, mesylate.

In formula L1 n may be an integer of from 1 to 400, preferably of from 2 to 200, more preferably from 2 to 150. In a particular embodiment n may be an integer from 2 to 50, in another embodiment n is 50 to 150.

In formula L1 m is 0 or, if a co-monomer is present, an integer from 1 to 400, preferably of from 1 to 200, more preferably from 2 to 150.

If a co-monomer is use, the ratio of n to m may be of from 10:90 to 95:5, preferably from 20:70 to 90:10, more preferably from 30:70 to 70:30.

Generally, the mass average molecular weight $M_w$ of the leveling agent may be from about 450 to about 150 000 g/mol, preferably 1 000 to 80 000 g/mol, most preferably 1 000 to 50 000 g/mol.

A first preferred embodiment of the leveler according to the present invention is a coupled aminoamide of formula L5

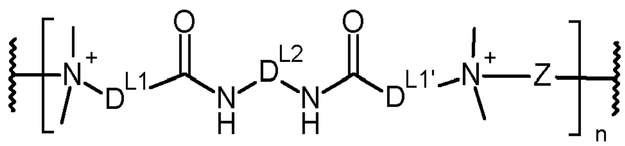

(L5)

with the general definitions provided above. Preferably $D^{L1}$ and $D^{L2}$ are independently selected from methanediyl, ethane-1,2-diyl, propane-1,2-diyl, propane-1,3-diyl, butane1,2-diyl, butane1,3-diyl, butane1,4-diyl. In another embodiment, cyclic alkanediyl groups $D^{L2}$ such as but not limited to

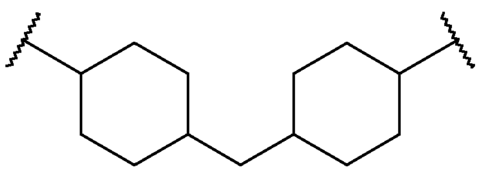

,

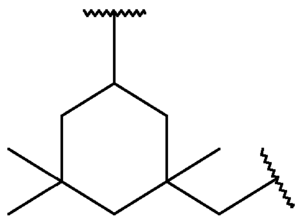

or

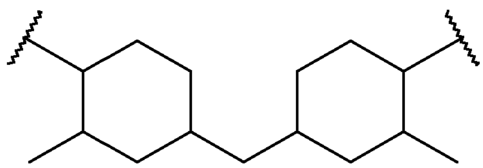

may be used.

A second preferred embodiment of a leveler according to the present invention is a coupled aminoamide of formula L6

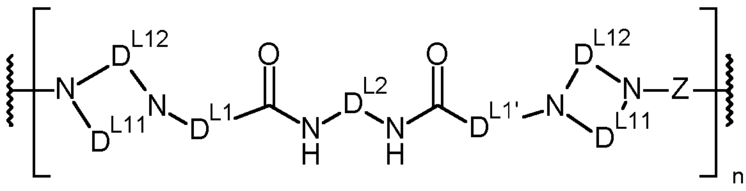

(L6)

with the general definitions provided above. Preferably $D^{L1}$ and $D^{L2}$ are independetly selected from metanediyl, ethane-1,2-diyl, propane-1,2-diyl, propane-1,3-diyl, butane1,2-diyl, butane1,3-diyl, and butane-1,4-diyl; $D^{L11}$ and $D^{L12}$ are (a) selected from methandiyl, ethanediyl, and propanediyl, or (b) both, together with the adjacent two N atoms, part of a 5 or 6-membered aromatic heterocyclic ring system. Particularly preferred levelers are those of formula L6a

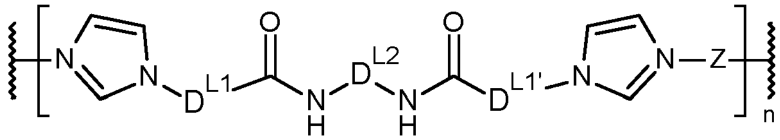

(L6a)

A third preferred embodiment of a leveler according to the present invention is a coupled aminoamide of formula L7

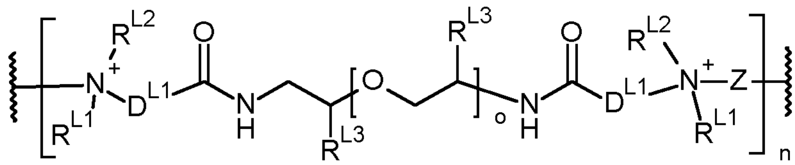

(L7)

with the general definitions provided above. Preferably $D^{L1}$ is selected from methandiyl, ethanediyl, propanediyl, butanediyl, pentanediyl, hexanediyl, heptanediyl, octanediyl, nonanediyl and decanediyl; $R^{L3}$ is selected from methyl, ethyl and propyl; and o is an interger from 2 to 50, preferably 2 to 40.

A fourth preferred embodiment of a leveler according to the present invention is a coupled aminoamide of formula L8

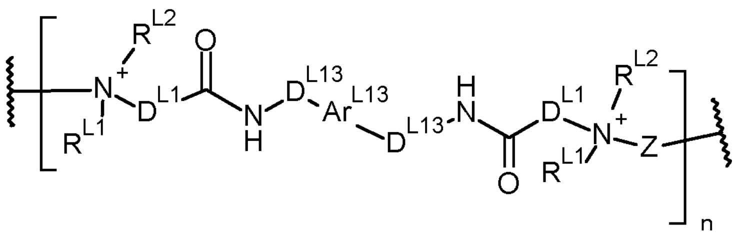

(L8)

with the general definitions provided above. Preferably $Ar^{L13}$ is phenylene, particularly phenyl-1,4-diyl; $D^{L13}$ and $D^{L1}$ are independently selected from methanediyl, ethanediyl, propanediyl, and butanediyl.

A fifth preferred embodiment of a leveler according to the present invention is a coupled aminoamide of formula L9

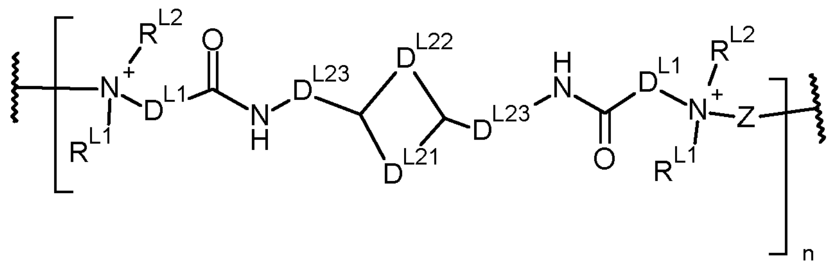

(L9)

with the general definitions provided above. Preferably $D^{L1}$ and $D^{L23}$ are independently selected from methanediyl, ethanediyl, propanediyl and butanediyl; $D^{L21}$ and $D^{L22}$ are independently selected from methandiyl, ethandiyl and

propanediyl; $R^{L1}$ and $R^{L2}$ are independently selected from methyl, ethyl, propyl, and butyl.

The aminoamide polymers described herein are usually terminated by tertiary amine groups or the partly reacted coupling agents 'z'.

Particularly preferrd polyaminoamide-type levelers are:

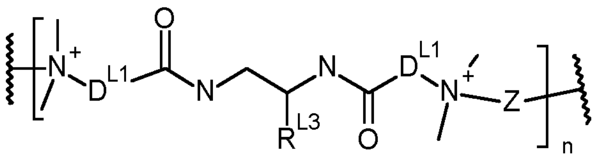

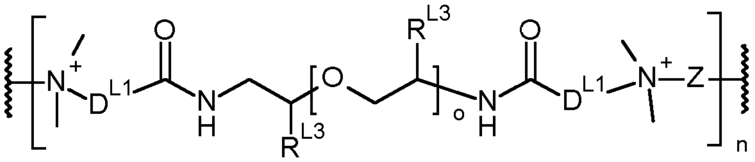

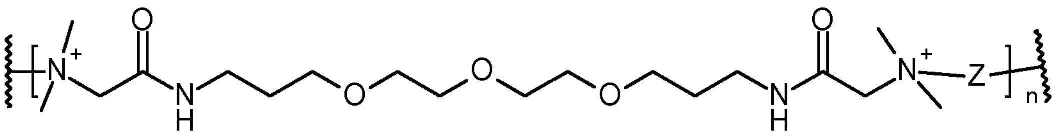

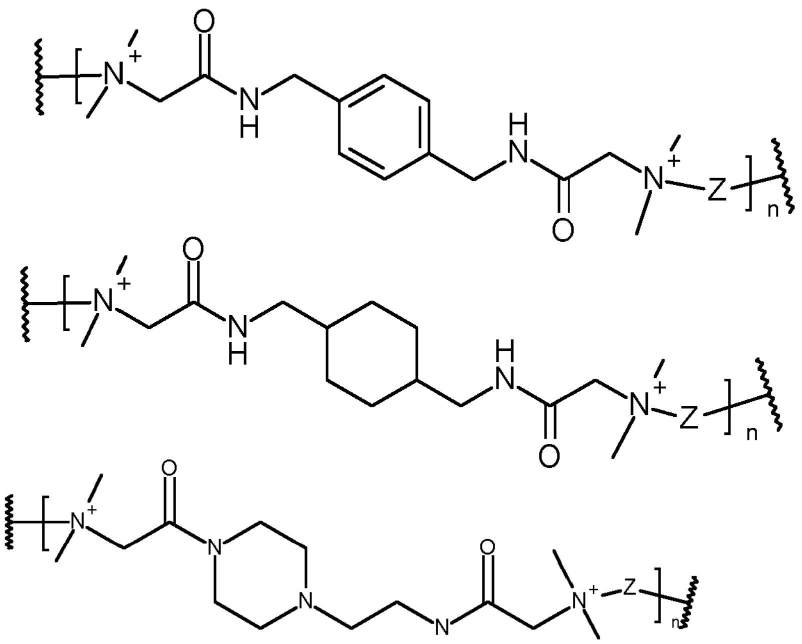

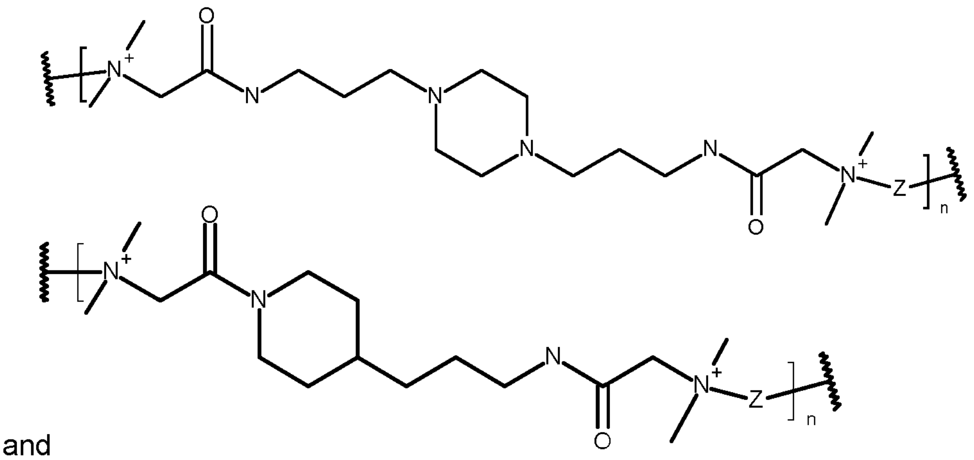

and

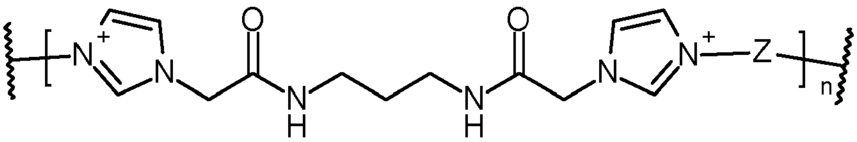

In an alternative embodiment of formula L1 m is equal to or greater than 1 and Y in is an amine co-monomer fragment received when an amine co-monomer 'y' comprising at least two tertiary or secondary amino groups is co-coupled together with the aminoamide compound. This co-coupling may be performed in mixture or in sequence in any order. Preferred is a co-coupling from a mixture comprising the aminoamide and the amine co-monomer.

Y may be a fragment of formula L3a or formula L3b. In this case Y may be the same or different from A and A'. Alternatively, Y may be other fragments disclosed on page 6 of
US 2016/0076160 A1 (independent of its counter ion $Cl^-$), which are incorporated herein by reference.

Particular preferred fragments Y are those received by reaction of 1-(Bis(3-dimethylamino)propyl)amino)-2-propanol, 4,4-trimethylenedipiperidine, tetramethyl-1,2 ethylenediamine, tetramethyl-1,3 propanediamine, tetramethyl-1,4 butanediamine, tetramethyl-1,6 hexanediamine, tetramethyl-1,8 octanediamine, tetraethyl-1,3 propanediamine, tetramethyl phenylenediamine, bis(dimethylaminoethyl)ether, tetramethyl-2-butene-1,4-diamine, tetramethyl-2,2-dimethyl-1,3 propanediamine. By using a co-monomer, the properties of the additive may be further influenced, e.g. by increasing or decreasing nitrogen-content, hydrophilicity, charge and charge density or other chemical or physical properties.

The condensation of the aminoacid and the diamine usually takes place by heating the aminoacid and the diamine, e.g. to temperatures of from 100 to 250 °C, preferably form 120 to 200 °C, and distilling off the water of reaction which forms in the condensation. If said aminoacid derivatives are used, the condensation may also be carried out at temperatures lower than those given. The preparation of the cationic aminoamide polymers can be carried out without the addition of a catalyst, or alternatively with the use of an acidic or basic catalyst. Suitable acidic catalysts are, for example, acids, such as Lewis acids, e.g. sulfuric acid, p-toluenesulfonic acid, phosphorous acid, hypophosphorous acid, phosphoric acid, methanesulfonic acid, boric acid, aluminum chloride, boron trifluoride, tetraethyl orthotitanate, tin dioxide, tin butyldilaurate or mixtures thereof. Suitable basic catalysts are, for example, alkoxides, such as sodium methoxide or sodium ethoxide, alkali metal hydroxides, such as potassium hydroxide, sodium hydroxide or lithium hydroxide, alkaline earth metal oxides, such as magnesium oxide or calcium oxide, alkali metal and alkaline earth metal carbonates, such as sodium, potassium and calcium carbonate, phosphates, such as potassium phosphate and complex metal hydrides, such as sodium borohydride. Where used, the catalyst is generally used in an amount of from 0.05 to 10% by weight, preferably 0.5 to 1% by weight, based on the total amount of the starting materials.

The reaction can be carried out in a suitable solvent or preferably in the absence of a solvent. If a solvent is used, suitable examples are hydrocarbons, such as toluene or xylene, nitriles, such as acetonitrile, amides, such as N,N-dimethylformamide, N,N-dimethylacetamide, N-methylpyrrolidone, ethers, such as diethylene glycol dimethyl ether, ethylene glycol dimethyl ether, ethylene carbonate, propylene carbonate and the like. The solvent is generally distilled off during the reaction or when the reaction is complete. This distillation can optionally be carried out under a protective gas, such as nitrogen or argon.

In general, the total amount of leveling agents in the electroplating bath is from 0.05 ppm to 10000 ppm based on the total weight of the plating bath. The leveling agents according to the present invention are typically used in a total amount of from about 0.1 ppm to about 1000 ppm based on the total weight of the plating bath and more typically from 1 to

100 ppm, although greater or lesser amounts may be used.

A large variety of additives may typically be used in the bath to provide desired surface finishes for the Cu plated metal. Usually more than one additive is used with each additive forming a desired function. Advantageously, the electroplating baths may contain one or more of accelerators, suppressors, sources of halide ions, grain refiners and mixtures thereof. Most preferably the electroplating bath contains both, an accelerator and a suppressor in addition to the leveling agent according to the present invention.

Other additives

A large variety of further additives may typically be used in the bath to provide desired surface finishes for the Cu plated metal. Usually more than one additive is used with each additive forming a desired function. Advantageously, the electroplating baths may contain one or more of accelerators, suppressors, sources of halide ions, grain refiners and mixtures thereof. Most preferably the electroplating bath contains both, an accelerator and a suppressing agent in addition to the leveling agent according to the present invention. Other additives may also be suitably used in the present electroplating baths.

Accelerators

Any accelerators may be advantageously used in the plating baths according to the present invention. As used herein, "accelerator" refers to an organic additive that increases the plating rate of the electroplating bath. The terms "accelerator" and "accelerating agent" are used interchangeably throughout this specification. In literature, sometimes the accelerator component is also named "brightener", "brightening agent", or "depolarizer". Accelerators useful in the present invention include, but are not limited to, compounds comprising one or more sulphur atom and a sulfonic/phosphonic acid or their salts. Preferably the composition further comprises at least one accelerating agent.

Preferred accelerators have the general structure $MO_3Y^{A}\text{-}^{A1}\text{-}(S)_dR^{A2}$, with:

- M is a hydrogen or an alkali metal, preferably Na or K;
- $Y^A$ is P or S, preferably S;
- d is an integer from 1 to 6, preferably 2;
- $X^{A1}$ is selected from a $C_1$-$C_8$ alkanediyl or heteroalkanediyl group, a divalent aryl group or a divalent heteroaromatic group. Heteroalkyl groups will have one or more heteroatom (N, S, O) and 1-12 carbons. Carbocyclic aryl groups are typical aryl groups, such as phenyl or naphthyl. Heteroaromatic groups are also suitable aryl groups and contain one or more N, O or S atom and 1-3 separate or fused rings.
- $R^{A2}$ is selected from H or ($-S-X^{A1'}Y^AO_3M$), wherein $X^{A1'}$ is independently selected from group $X^{A1}$.

More specifically, useful accelerators include those of the following formulae:

$$MO_3S\text{-}X^{A1}\text{-}SH$$

$$MO_3S\text{-}X^{A1}\text{-}S\text{-}S\text{-}X^{A1'}\text{-}SO_3M$$

$$MO_3S\text{-}Ar\text{-}S\text{-}S\text{-}Ar\text{-}SO_3M$$

wherein $X^{A1}$ is as defined above and Ar is aryl.

Particularly preferred accelerating agents are:

- SPS: bis-(3-sulfopropyl)-disulfide
- MPS: 3-mercapto-1-propansulfonic acid.

Both are usually applied in form of their salts, particularly their sodium salts.

Other examples of accelerators, used alone or in mixture, include, but are not limited to: MES (2-Mercaptoethanesulfonic acid, sodium salt); DPS (N,N-dimethyldithiocarbamic acid (3-sulfopropylester), sodium salt); UPS (3-[(amino-iminomethyl)-thio]-1-propylsulfonic acid); ZPS (3-(2-benzthiazolylthio)-1-propanesulfonic acid, sodium salt); 3-mercapto-propylsulfonicacid-(3-sulfopropyl)ester; methyl-(ϖ-sulphopropyl)-disulfide, disodium salt; methyl-(ϖ-sulphopropyl)-trisulfide, disodium salt.

Such accelerators are typically used in an amount of about 0.1 ppm to about 3000 ppm, based on the total weight of the plating bath. Particularly suitable amounts of accelerator useful in the present invention are 1 to 500 ppm, and more particularly 2 to 100 ppm.

Suppressing agents

Suppressing agents may advantageously used in combination with the levelers according to the present inventions. As used herein, "suppressing agents" are additives which increase the overpotential during electrodeposition. There terms "surfactant" and "suppressing agent" are synonymously used since the suppressing agents described herein are also surface-active substances. Usually suppressing agents comprise oxy($C_2$ to $C_4$)alkylene homo- or coplymers, obtainable by polyoxyalkylation of an alcohol or amine starter.
Particularly useful suppressing agents are:

(a) Suppressing agents obtainable by reacting an amine compound comprising at least three active amino functional groups with a mixture of ethylene oxide and at least one compound selected from $C_3$ and $C_4$ alkylene oxides as described in WO 2010/115796.
Preferably the amine compound is selected from diethylene triamine, 3-(2-aminoethyl)aminopropylamine, 3,3'-iminodi(propylamine), N,N-bis(3-aminopropyl)methylamine, bis(3-dimethylaminopropyl)amine, triethylenetetraamine and N,N'-bis(3-aminopropyl)ethylenediamine.

(b) Suppressing agents obtainable by reacting an amine compound comprising active amino functional groups with a mixture of ethylene oxide and at least one compound selected from $C_3$ and $C_4$ alkylene oxides, said suppressing agent having a molecular weight $M_w$ of 6000 g/mol or more, forming an ethylene $C_3$ and/or $C_4$ alkylene random copolymer as described in WO 2010/115756.

(c) Suppressing agent obtainable by reacting an amine compound comprising at least three active amino functional groups with ethylene oxide and at least one compound selected from $C_3$ and $C_4$ alkylene oxides from a mixture or in sequence, said suppressing agent having a molecular weight $M_w$ of 6000 g/mol or more as described in WO 2010/115757.

Preferably the amine compound is selected from ethylene diamine, 1,3-diaminopropane, 1,4-diaminobutane, 1,5-diaminopentane, 1,6-diaminohexane, neopentanediamine, isophoronediamine, 4,9-dioxadecane-1,12-diamine, 4,7,10-trioxyatridecane-1,13-diamine, triethylene glycol diamine, diethylene triamine, (3-(2-aminoethyl)aminopropylamine, 3,3'-iminodi(propylamine), N,N-bis(3-aminopropyl)methylamine, bis(3-dimethylaminopropyl)amine, triethylenetetraamine and N,N'-bis(3-aminopropyl)ethylenediamine.
(d) Suppressing agent selected from compounds of formula S1

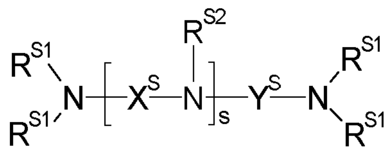

(S1)

wherein the $R^{S1}$ radicals are each independently selected from a copolymer of ethylene oxide and at least one further $C_3$ to $C_4$ alkylene oxide, said copolymer being a random copolymer, the $R^{S2}$ radicals are each independently selected from $R^{S1}$ or alkyl, $X^S$ and $Y^S$ are spacer groups independently, and $X^S$ for each repeating unit s independently, selected from $C_2$ to $C_6$ alkandiyl and $Z^S$-(O-$Z^S$)$_t$ wherein the $Z^S$ radicals are each independently selected from $C_2$ to $C_6$ alkandiyl, s is an integer equal to or greater than 0, and t is an integer equal to or greater than 1, as described in WO 2010/115717.
Preferably spacer groups $X^S$ and $Y^S$ are independently, and $X^S$ for each repeating unit independently, selected from $C_2$ to $C_4$ alkylene. Most preferably $X^S$ and $Y^S$ are independently, and $X^S$ for each repeating unit s independently, selected from ethylene (-$C_2H_4$-) or propylene (-$C_3H_6$-).
Preferably $Z^S$ is selected from $C_2$ to $C_4$ alkylene, most preferably from ethylene or propylene.
Preferably s is an integer from 1 to 10, more preferably from 1 to 5, most preferably from 1 to 3.
Preferably t is an integer from 1 to 10, more preferably from 1 to 5, most preferably from 1 to 3.
In another preferred embodiment the $C_3$ to $C_4$ alkylene oxide is selected from propylene oxide (PO). In this case EO/PO copolymer side chains are generated starting from the active amino functional groups
The content of ethylene oxide in the copolymer of ethylene oxide and the further $C_3$ to $C_4$ alkylene oxide can generally be from about 5 % by weight to about 95 % by weight, preferably from about 30 % by weight to about 70 % by weight, particularly preferably between about 35 % by weight to about 65 % by weight.
The compounds of formula (S1) are prepared by reacting an amine compound with one ore more alkylene oxides. Preferably the amine compound is selected from ethylene diamine, 1,3-diaminopropane, 1,4-diaminobutane, 1,5-diaminopentane, 1,6-diaminohexane, neopentanediamine, isophoronediamine, 4,9-dioxadecane-1,12-diamine,

4,7,10-trioxatridecane-1,13-diamine, triethylene glycol diamine, diethylene triamine, (3-(2-aminoethyl)amino)propylamine, 3,3'-iminodi(propylamine), N,N-bis(3-aminopropyl)methylamine, bis(3-dimethylaminopropyl)amine, triethylenetetraamine and N,N'-bis(3-aminopropyl)ethylenediamine.

The molecular weight $M_w$ of the suppressing agent of formula S1 may be between about 500 g/mol to about 30000 g/mol. Preferably the molecular weight $M_w$ should be about 6000 g/mol or more, preferably from about 6000 g/mol to about 20000 g/mol, more preferably from about 7000 g/mol to about 19000 g/mol, and most preferably from about 9000 g/mol to about 18000 g/mol. Preferred total amounts of alkylene oxide units in the suppressing agent may be from about 120 to about 360, preferably from about 140 to about 340, most preferably from about 180 to about 300.

Typical total amounts of alkylene oxide units in the suppressing agent may be about 110 ethylene oxide units (EO) and 10 propylene oxide units (PO), about 100 EO and 20 PO, about 90 EO and 30 PO, about 80 EO and 40 PO, about 70 EO and 50 PO, about 60 EO and 60 PO, about 50 EO and 70 PO, about 40 EO and 80 PO, about 30 EO and 90 PO, about 100 EO and 10 butylene oxide (BO) units, about 90 EO and 20 BO, about 80 EO and 30 BO, about 70 EO and 40 BO, about 60 EO and 50 BO or about 40 EO and 60 BO to about 330 EO and 30 PO units, about 300 EO and 60 PO, about 270 EO and 90 PO, about 240 EO and 120 PO, about 210 EO and 150 PO, about 180 EO and 180 PO, about 150 EO and 210 PO, about 120 EO and 240 PO, about 90 EO and 270 PO, about 300 EO and 30 BO units, about 270 EO and 60 BO, about 240 EO and 90 BO, about 210 EO and 120 BO, about 180 EO and 150 BO, or about 120 EO and 180 BO.

(e) Suppressing agent obtainable by reacting a polyhydric alcohol condensate compound derived from at least one polyalcohol of formula (S2) $X^S(OH)_u$ by condensation with at least one alkylene oxide to form a polyhydric alcohol condensate comprising polyoxyalkylene side chains, wherein u is an integer from 3 to 6 and $X^S$ is an u-valent linear or branched aliphatic or cycloaliphatic radical having from 3 to 10 carbon atoms, which may be substituted or unsubstituted, as described in WO 2011/012462.

Preferred polyalcohol condensates are selected from compounds of formulae

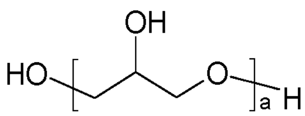

(S2a)

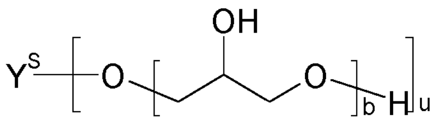

(S2b)

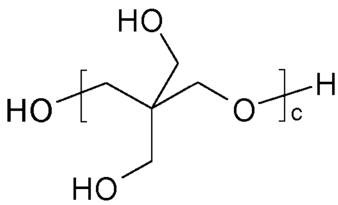

(S2c)

wherein $Y^S$ is an u-valent linear or branched aliphatic or cycloaliphatic radical having from 1 to 10 carbon atoms, which may be substituted or unsubstituted, a is an integer from 2 to 50, b may be the same or different for each polymer arm u and is an integer from 1 to 30, c is an integer from 2 to 3, and u is an integer from 1 to 6. Most preferred Polyalcohols are glycerol condensates and/or pentaerythritol condensates.

(f) Suppressing agent obtainable by reacting a polyhydric alcohol comprising at least 5 hydroxyl functional groups with at least one alkylene oxide to form a polyhydric alcohol comprising polyoxyalkylene side chains as described in WO 2011/012475. Preferred polyalcohols are linear or cyclic monosaccharide alcohols represented by formula (S3a) or (S3b)

$$HOCH_2\text{-}(CHOH)_v\text{-}CH_2OH \qquad (S3a)$$

$$(CHOH)_w \qquad (S3b)$$

wherein v is an integer from 3 to 8 and w is an integer from 5 to 10. Most preferred monosaccharide alcohols are sorbitol, mannitol, xylitol, ribitol and inositol. Further preferred polyalcohols are monosaccharides of formula (S4a) or (S4b)

$$CHO\text{-}(CHOH)_x\text{-}CH_2OH \qquad (S4a)$$

$$CH_2OH-(CHOH_y-CO-(CHOH)_z-CH_2OH \quad (S4b)$$

wherein x is an integer of 4 to 5, and y, z are integers and y + z is 3 or 4. Most preferred monosaccharide alcohols are selected from the aldoses allose, altrose, galactose, glucose, gulose, idose, mannose, talose, glucoheptose, mannoheptose or the ketoses fructose, psicose, sorbose, tagatose, mannoheptulose, sedoheptulose, taloheptulose, alloheptulose.

(g) amine-based polyoxyalkylene suppressing agents based on cyclic amines show extraordinary superfilling properties, as described in WO 2018/073011.

(h) polyamine-based or polyhydric alcohol-based suppressing agents which are modified by reaction with a compound, such as but not limited to glycidole or glycerol carbonate, that introduce a branching group into the suppressing agent before they are reacted with alkylene oxides show extraordinary superfilling properties, as described in WO 2018/114985.

When suppressors are used, they are typically present in an amount in the range of from about 1 to about 10,000 ppm based on the weight of the bath, and preferably from about 5 to about 10,000 ppm.

It will be appreciated by those skilled in the art that more than one leveling agent may be used. When two or more leveling agents are used, at least one of the leveling agents is a leveling agent according to the invention or a derivative thereof as described herein. It is preferred to use only one leveling agent in the plating composition.

Further leveling agents

Additional leveling agents can advantageously be used in the copper electroplating baths according to the present invention. When two or more leveling agents are used, at least one of the leveling agents is a polyalkoxylated polyalkyleneimine or a derivative thereof as described herein. It is preferred to use only one leveling agent in the plating composition that is a polyalkoxylated polyalkylenepolyamine according to the invention.

Suitable additional leveling agents include, but are not limited to, one or more of other polyethylene imines and derivatives thereof, quaternized polyethylene imine, polyglycine, poly(allylamine), polyaniline, polyurea, polyacrylamide, poly(melamine-co-formaldehyde), reaction products of amines with epichlorohydrin, reaction products of an amine, epichlorohydrin, and polyalkylene oxide, reaction products of an amine with a polyepoxide, polyvinylpyridine, polyvinylimidazole as described e.g. in WO 2011/151785 A1, polyvinylpyrrolidone, polyaminoamides as described e.g. in WO 2011/064154 A2 and WO 2014/072885 A2, or copolymers thereof, nigrosines, pentamethyl-para-rosaniline hydrohalide, hexamethyl-pararosaniline hydrohalide, di- or trialkanolamines and their derivatives as described in WO 2010/069810, biguanides as described in WO 2012/085811 A1, or a compound containing a functional group of the formula N-R-S, where R is a substituted alkyl, unsubstituted alkyl, substituted aryl or unsubstituted aryl. Typically, the alkyl groups are $C_1$-$C_6$ alkyl and preferably $C_1$-$C_4$ alkyl. In general, the aryl groups include $C_6$-$C_{20}$ aryl, preferably $C_6$-$C_{10}$ aryl. It is preferred that the aryl group is phenyl or naphthyl. The compounds containing a functional group of the formula N-R-S are generally known, are generally commercially available and may be used without further purification.

In such compounds containing the N-R-S functional group, the sulfur ("S") and/or the nitrogen ("N") may be attached to such compounds with single or double bonds. When the sulfur is attached to such compounds with a single bond, the sulfur will have another substituent group, such as but not limited to hydrogen, $C_1$-$C_{12}$ alkyl, $C_2$-$C_{12}$ alkenyl, $C_6$-$C_{20}$ aryl, $C_1$-$C_{12}$ alkylthio, $C_2$-$C_{12}$ alkenylthio, $C_6$-$C_{20}$ arylthio and the like. Likewise, the nitrogen will have one or more substituent groups, such as but not limited to hydrogen, $C_1$-$C_{12}$ alkyl, $C_2$-$C_{12}$ alkenyl, $C_7$-$C_{10}$ aryl, and the like. The N-R-S functional group may be acyclic or cyclic. Compounds containing cyclic N-R-S functional groups include those having either the nitrogen or the sulfur or both the nitrogen and the sulfur within the ring system.

In general, the total amount of leveling agents in the electroplating bath is from 0.5 ppm to 10000 ppm based on the total weight of the plating bath. The leveling agents according to the present invention are typically used in a total amount of from about 0.1 ppm to about 1000 ppm based on the total weight of the plating bath and more typically from 1 to 100 ppm, although greater or lesser amounts may be used.

More details and alternatives are described in WO 2018/219848, WO 2016/020216, and WO 2010/069810, respectively, which are incorporated herein by reference.

In general, the total amount of leveling agents in the electroplating bath is from 0.5 ppm to 10000 ppm based on the total weight of the plating bath. The leveling agents according to the present invention are typically used in a total amount of from about 100 ppm to about 10000 ppm based on the total weight of the plating bath, although greater or lesser amounts may be used.

Electrolyte

The electroplating composition according to the present invention comprises and electrolyte comprising copper ions and an acid.

Copper ions

The source of copper ions may be any compound capable of releasing metal ions to be deposited in the electroplating bath in sufficient amount, i.e. is at least partially soluble in the electroplating bath. It is preferred that the metal ion source is soluble in the plating bath. Suitable metal ion sources are metal salts and include, but are not limited to, sulfates, halides, acetates, nitrates, fluoroborates, alkylsulfonates, arylsulfonates, sulfamates, metal gluconates and the like.

The metal ion source may be used in the present invention in any amount that provides sufficient metal ions for electroplating on a substrate. When the metal is solely copper, it is typically present in an amount in the range of from about 1 to about 300 g/l of plating solution, preferably from about 20 to about 100 g/l, most preferably from about 40 to about 70 g/l.

Optionally, the plating baths according to the invention may contain one or more alloying metal ions up to an amount of 10 % by weight, preferably up to 5 % by weight, most preferably up to 2 % by weight. Suitable alloying metals include, without limitation, silver, gold, tin, bismuth, indium, zinc, antimony, manganese and mixtures thereof. Preferred alloying metals are silver, tin, bismuth, indium, and mixtures thereof, and more preferably tin. Any bath-soluble salt of the alloying metal may suitably be used as the source of alloying metal ions. Examples of such alloying metal salts include but are not limited to: metal oxides; metal halides; metal fluoroborate; metal sulfates; metal alkanesulfonates such as metal methanesulfonate, metal ethanesulfonate and metal propanesulfonate; metal arylsulfonates such as metal phenylsulfonate, metal toluenesulfonate, and metal phenol sulfonate; metal carboxylates such as metal gluconate and metal acetate; and the like. Preferred alloying metal salts are metal sulfates; metal alkanesulfonates; and metal arylsulfonates. When one alloying metal is added to the present compositions, a binary alloy deposit is achieved. When 2, 3 or more different alloying metals are added to the present compositions, tertiary, quaternary or higher order alloy deposits are achieved. The amount of such alloying metal used in the present compositions will depend upon the particular tin-alloy desired. The selection of such amounts of alloying metals is within the ability of those skilled in the art. It will be appreciated by those skilled in the art that when certain alloying metals, such as silver, are used, an additional complexing agent may be required. Such complexing agents (or complexers) are well-known in the art and may be used in any suitable amount to achieve the desired tin-alloy composition.

In a preferred embodiment the plating solution is essentially free of tin, that is, they contain below 1 % by weight tin, more preferably below 0.1 % by weight tin, and yet more preferably below 0.01 % by weight tin, and still more preferably are free of tin. In another preferred embodiment the plating solution is essentially free of any alloying metal, that is, they contain below 1 % by weight alloying metal, more preferably below 0.1 % by weight alloying metal, even more preferably below 0.01 % by weight alloying metal, and still more preferably are free of alloying metal. Most preferably the metal ions consist of copper ions, i.e. are free of any other ions besides copper.

The present electroplating compositions are suitable for depositing a copper-containing layer, which may preferably be a pure copper layer or alternatively a copper alloy layer comprising up to 10 % by weight, preferably up to 5 % by weight, most preferably up to 2 % by weight of the alloying metal(s). Exemplary copper alloy layers include, without limitation, tin-silver, tin-copper, tin-indium, tin-bismuth, tin-silver-copper, tin-silver-copper-antimony, tin-silver-copper-manganese, tin-silver-bismuth, tin-silver-indium, tin-silver-zinc-copper, and tin-silver-indium-bismuth. Preferably, the present electroplating compositions deposit pure tin, tin-silver, tin-silver-copper, tin-indium, tin-silver-bismuth, tin-silver-indium, and tin-silver-indium-bismuth, and more preferably pure tin, tin-silver or tin-copper.

The alloy metal content may be measured by either atomic adsorption spectroscopy (AAS), X-ray fluorescence (XRF), inductively coupled plasma mass spectrometry (ICP-MS).

In general, besides the copper ions and at least one of the leveling agents, the present copper electroplating compositions preferably include an electrolyte, i. e. acidic or alkaline electrolyte, optionally halide ions, and optionally other additives like accelerators and suppressing agents.

Such baths are typically aqueous. In general, as used herein "aqueous" means that the present electroplating compositions comprises a solvent comprising at least 50 % of water. Preferably, "aqueous" means that the major part of the composition is water, more preferably 90% of the solvent is water, most preferably the solvent consists or essentially consists of water. Any type of water may be used, such as distilled, deinonized or tap.

Acid

The plating baths of the invention are acidic, that is, they have a pH below 7. Typically, the pH of the copper electroplating composition is below 4, preferably below 3, most preferably below 2. The pH mainly depends on the concentration of the acid present in the composition.

Suitable acids include inorganic acids and organic acids, such as, but not limited to, sulfuric acid, acetic acid, fluoroboric acid, alkylsulfonic acids such as methanesulfonic acid, ethanesulfonic acid, propanesulfonic acid and trifluoromethane sulfonic acid, arylsulfonic acids such as phenyl sulfonic acid and toluenesulfonic acid, sulfamic acid, hydrochloric acid, and phosphoric acid. Sulfuric acid and methanesulfonic acid are preferred.

The acids are typically present in an amount in the range of from about 1 to about 300 g/l, preferably from about 60 to about 200 g/l, most preferably from about 80 to about 140 g/l.

Such electrolytes may optionally (and preferably) contain a source of halide ions, such as chloride ions as in copper chloride or hydrochloric acid. A wide range of halide ion concentrations may be used in the present invention such as from about 0 to about 500 ppm. Preferably, the halide ion concentration is in the range of from about 10 to about 100 ppm based on the plating bath. It is preferred that the electrolyte is sulfuric acid or methanesulfonic acid, and preferably a mixture of sulfuric acid or methanesulfonic acid and a source of chloride ions. The acids and sources of halide ions useful in the present invention are generally commercially available and may be used without further purification.

Process

The composition according to the invention is particularly useful for electrodepositing copper on a substrate comprising a recessed feature comprising a conductive feature bottom and a dielectric feature side wall, wherein the recessed feature has an aperture size from 500 nm to 500 μm. The leveling agents according to the present invention are particularly useful for filling of recessed features having aperture sizes of 1 to 200 μm. The leveling agents are particularly useful for depositing copper bumps.

The copper is deposited in recesses according to the present invention without substantially forming voids within the metal deposit. By the term "without substantially forming voids", it is meant that there are no voids in the metal deposit which are bigger than 1000 nm, preferably no voids in the metal deposit which are bigger than 500 nm, most preferably no voids in the metal deposit which are bigger than 100 nm. Most preferably the deposit is free of any defects.

Due to the leveling effect of the leveling agents, surfaces are obtained with an improved coplanarity of the plated copper bumps. The copper deposits show a good morphology, particularly a low roughness. The electroplating composition is capable of filling recessed features on the micrometer scale without substantially forming defects, such as but not limited to voids.

Furthermore, the leveling agents according to the invention lead to reduced impurities, such as but not limited to organics, chloride, sulfur, nitrogen, or other elements. It shows large grains and an improved conductivity. It also facilitates high plating rates and allows plating at elevated temperature.

In general, when the present invention is used to deposit copper on a substrate the plating baths are agitated during use. Any suitable agitation method may be used with the present invention and such methods are well-known in the art. Suitable agitation methods include, but are not limited to, inert gas or air sparging, work piece agitation, impingement and the like. Such methods are known to those skilled in the art. When the present invention is used to plate an integrated circuit substrate, such as a wafer, the wafer may be rotated such as from 1 to 150 RPM and the plating solution contacts the rotating wafer, such as by pumping or spraying. In the alternative, the wafer need not be rotated where the flow of the plating bath is sufficient to provide the desired metal deposit.

Plating equipments for plating semiconductor substrates are well known. Plating equipment comprises an electroplating tank which holds copper electrolyte and which is made of a suitable material such as plastic or other material inert to the electrolytic plating solution. The tank may be cylindrical, especially for wafer plating. A cathode is horizontally disposed at the upper part of tank and may be any type substrate such as a silicon wafer having openings.

These additives can be used with soluble and insoluble anodes in the presence or absence of a membrane or membranes separating the catholyte from the anolyte.

The cathode substrate and anode are electrically connected by wiring and, respectively, to a power supply. The cathode substrate for direct or pulse current has a net negative charge so that the metal ions in the solution are reduced at the cathode substrate forming plated metal on the cathode surface. An oxidation reaction takes place at the anode. The cathode and anode may be horizontally or vertically disposed in the tank.

In general, when preparing copper bumps, a photoresist layer is applied to a semiconductor wafer, followed by standard photolithographic exposure and development techniques to form a patterned photoresist layer (or plating mask) having recessed features or vias therein. The dimensions of the dielectric plating mask (thickness of the plating mask and the size of the openings in the pattern) defines the size and location of the copper layer deposited over the I/O pad and UBM. The diameter of such deposits typically range of from 1 to 300 μm, preferably in the range from 2 to 100 μm. Usually the recesses provided by the plating mask are not fully but only partly filled. After filling the openings in the plating mask with copper, the plating mask is removed, and then the copper bumps are usually subjected to reflow processing.

Typically, the plating baths of the present invention may be used at any temperature from 10 to 65 degrees C or higher. It is preferred that the temperature of the plating baths is from 10 to 35 degrees C and more preferably from 15 degrees to 30 degrees C.

All percent, ppm or comparable values refer to the weight with respect to the total weight of the respective composition except where otherwise indicated. All cited documents are incorporated herein by reference.

The following examples shall further illustrate the present invention without restricting the scope of this invention.

Analytical Methods

The molecular weight of the suppressing agents was determined by size-exclusion chromatography (SEC). Polystyrene was used as standard and tetrahydrofuran as effluent. The temperature of the column was 30°C, the injected volume 30 μl (microliter) and the flow rate 1.0 ml/min. The weight average molecular weight ($M_w$), the number average molecular weight ($M_n$) and the polydispersity PDI ($M_w/M_n$) of the suppressing agent were determined.

The amine number was determined according to DIN 53176 by titration of a solution of the polymer in acetic acid with perchloric acid.

The experiments were performed by using a 300 mm silicon wafer segment with a patterned photoresist 120 μm thick and a plurality of copper seeded 75 micrometers opening vias (available from IMAT, Inc., Vancouver, WA, USA).

The electroplated copper was investigated by a 3D laser scanning microscope (3D LSM). The height of the deposited copper layer in the bumps was determined visually.

The non-uniformity was determined from heights of totally 27 measured bumps, where 15 bumps in the dense area with a pitch size of 150 μm and 12 bumps with a pitch size of 375 μm were measured.

The coplanarity, an indicator of non-uniformity, was calculated from the heights by using the following formula:

$$\text{COP [\%]} = \frac{bump\ height\ average\ iso - \ bump\ height\ average\ dense}{mean\ height} \times 100$$

wherein

"bump height average iso" and "bump height average dense" are the arithmetic mean of each area. "mean height" is calculated by the sum of "bump height average iso" and "bump height average dense" divided by 2.

Examples

Example 1: Leveler preparation

Example 1.1

The reaction was placed in a 0.5 l reactor equipped with a stirrer, condenser tube, thermometer, and nitrogen inlet pipe. Poly(propylene glycol) bis(2-aminopropyl ether (n~6), available from BASF, (225.8 g) and hypophosphoric acid (0.3 g) were placed into the reactor under nitrogen atmosphere and heated up to 80 °C. Then N, N-Dimethylglycine (106.3 g) was added in portion over a period of 20 min. After complete addition of the acid, the reaction mixture was stirred at 120°C for 1h. Then the temperature was increased up to 150 °C and the reaction mixture was stirred over 8 hours while removing the resulting water out of the system. A pre-product was obtained as brown oil with an amine value of 3.3 mmol/g (yield: 94%).

The pre-product (85 g) and water (108 g) were placed into a 250 ml flask, heated up to 80 °C and stirred over 20 min. Then epichlorohydrin (23 g) was added dropwise over a period of 90 min. To complete the reaction, the mixture post-react for 18.5 h until the Preussmann test was negative. The product (Leveler 1) was obtained as orange, viscous solution with a chloride value of 1.02 mmol/g (yield: 98 %).

Example 1.2:

The reaction was placed in a 0.5 l reactor equipped with a stirrer, condenser tube, thermometer, and nitrogen inlet pipe. Poly(propylene glycol) bis(2-aminopropyl ether (n~2), available from BASF, (150.0 g) and hypophosphoric acid (0.3 g) were placed into the reactor under nitrogen atmosphere and heated up to 80 °C. Then N, N-Dimethylglycine (129.7 g) was added in portion over a period of 20 min. After complete addition of the acid, the reaction mixture was stirred at 120°C for 1h. Then the temperature was increased up to 150 °C and the reaction mixture was stirred over 8 hours while removing the resulting water out of the system. A pre-product was obtained as brown oil with an amine value of 5.2 mmol/g (yield: 93%).

The pre-product (85 g) and water (123 g) were placed into a 250 ml flask, heated up to 80 °C and stirred over 20 min. Then epichlorohydrin (37.9 g) was added dropwise over a period of 90 min. To complete the reaction, the mixture post-react for 18 h until the Preussmann test was negative. The product (Leveler 2) was obtained as orange, viscous solution with a chloride value of 1.4 mmol/g (yield: 99 %).

Example 2: Electroplating experiments

Example 2.1 Comparative

A copper electroplating bath containing 51 g/l Cu ions, 100 g/l sulfuric acid and 50 ppm chloride has been used for the studies. In addition, the bath contains the following additives: 50 ppm SPS and 100 ppm of an ethylene oxide polymer suppressor with an average molecular weight of 4000 g/mol.

The substrate is prewetted and electrically contacted prior plating. The copper layer was plated by using a bench top plating tool available from Yamamoto MS. The electrolyte convection was realized by a pump and a paddle in front of the substrate. The RPM of the paddle for all plating conditions were 50 RPM. Bath temperature was controlled and set to 25 °C and the applied current density was 4 ASD for 340 s and 8 ASD for 1875 s resulting in bumps of approximately 50 µm height.

The plated bumps were examined with an LSM as described in detail above. A coplanarity (COP) 24.7 % was determined.

Example 2.2

A copper electroplating bath containing 51 g/l Cu ions, 100 g/l sulfuric acid and 50 ppm chloride has been used for the studies. In addition, the bath contains the following additives: 50 ppm SPS, 100 ppm of an ethylene oxide polymer suppressor with an average molecular weight of 4000 g/mol and 20 ppm of Leveler 1 of example 1.1.

The substrate is prewetted and electrically contacted prior plating. The copper layer was plated by using a bench top plating tool available from Yamamoto MS. The electrolyte convection was realized by a pump and a paddle in front of the substrate. The RPM of the paddle for all plating conditions were 50 RPM. Bath temperature was controlled and set to 25 °C and the applied current density was 4 ASD for 340 s and 8 ASD for 1875 s resulting in bumps of approximately 50 µm height.

The plated bumps were examined with an LSM as described in detail above. A coplanarity (COP) 14.4 % was determined.

The results are summarized in Table 1.

Example 2.3

A copper electroplating bath containing 51 g/l Cu ions, 100 g/l sulfuric acid and 50 ppm chloride has been used for the studies. In addition, the bath contains the following additives: 50 ppm SPS, 100 ppm of an ethylene oxide polymer suppressor with an average molecular weight of 4000 g/mol and 20 ppm of Leveler 2 of example 1.2.

The substrate is prewetted and electrically contacted prior plating. The copper layer was plated by using a bench top plating tool available from Yamamoto MS. The electrolyte convection was realized by a pump and a paddle in front of the substrate. The RPM of the paddle for all plating conditions were 50 RPM. Bath temperature was controlled and set to 25 °C and the applied current density was 4 ASD for 340 s and 8 ASD for 1875 s resulting in bumps of approximately 50 µm height.

The plated bumps were examined with an LSM as described in detail above. A coplanarity (COP) 15.6 % was determined.

Table 1

| Example | Leveler | COP [%] |
|---|---|---|
| 2.1 | n/a | 24.7 |
| 2.2 | [Poly(propylene glycol) bis(2-aminopropyl ether (n~6) + N,N-dimethylglycine] + Epichlorohydrine | 14.4 |
| 2.3 | [Poly(propylene glycol) bis(2-aminopropyl ether (n~2) + N,N-dimethylglycine] + Epichlorohydrine | 15.6 |

Table 1 shows that all levelers lead to copper deposits that have a very good coplanarity and a much better coplanarity compared to comparative example 2.1 without leveler.

## Claims

1. A copper electroplating composition comprising copper ions, an acid, and at least one polyaminoamide comprising a group of formula L1

$[B\text{-}A\text{-}B'\text{-}Z]_n[Y\text{-}Z]_m$ (L1)

wherein

B, B' are the same or different, preferably the same, and are aminoacid fragments of formula L2a

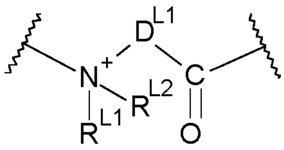

(L2a)

or of Formula L2b

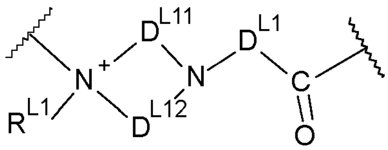

(L2b)

A is a diamine fragment independently selected from formula L3a

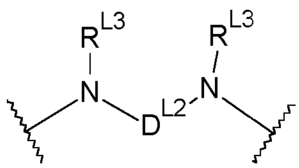

(L3a)

or of Formula L3b

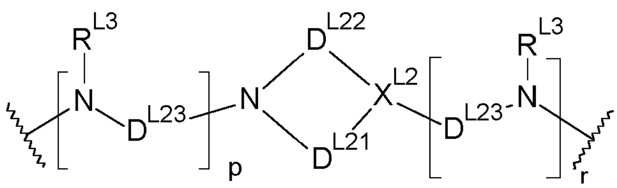

(L3b)

$D^{L1}$ is selected from a divalent group selected from

(a) a $C_1$-$C_{20}$-alkanediyl which may optionally be substituted by an amino group or interrupted by a double bond or an imino group,
(b) an ether or polyether group of formula L2a

$-(D^{L10}\text{-}O\text{-}]_o D^{L10}\text{-}$ (L2c)

$D^{L2}$ is a divalent group selected from

(a) a linear, branched or cyclic $C_1$ to $C_{20}$ alkanediyl, which may optionally be interrupted by one ore more $NRL^{10}$, or substituted by one or more, preferably 1 or 2, groups $NR^{L10}R^{L11}$ or $OR^{L10}$, or
(b) $-D^{L13}\text{-}Ar^{L13}\text{-}D^{L13}\text{-}$; or
(c) an ether or polyether group of formula L2c

$D^{L10}$ is selected from a linear or branched $C_1$-$C_6$-alkanediyl, preferably ethanediyl or propanediyl;
$D^{L13}$ is selected from a $C_1$-$C_6$-alkanediyl, preferably methanediyl or ethanediyl;
$Ar^{L13}$ is a $C_6$ to $C_{10}$ aromatic moiety, preferably p-phenylene;
$D^{L11}$,$D^{L12}$ are

(a) independently selected from a linear or branched $C_1$ to $C_6$ alkanediyl, or
(b) both, together with the adjacent two N atoms, part of a 5 or 6-membered aromatic heterocyclic ring system;

$D^{L21}$ ,$D^{L22}$ are

(a) independently selected from a linear or branched $C_1$ to $C_6$ alkanediyl, or
(b) both, together with the adjacent two N atoms, part of a 5 or 6-membered aromatic heterocyclic ring system;

$D^{L23}$ is a $C_1$ to $C_6$ alkanediyl;
$R^{L1}$, $R^{L2}$ are independently selected from a $C_1$ to $C_6$ alkyl;
$R^{L3}$ is selected form H and a $C_1$ to $C_6$ alkyl;
$X^{L2}$ is N or $CR^{L3}$;
Y is a co-monomer fragment;
Z is a divalent coupling fragment of formula L4

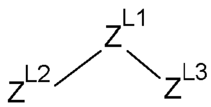

(L4)

$Z^{L1}$ is selected from

(a) a linear or branched $C_1$ to $C_{12}$ alkanediyl, which may be interrupted by one or more O atoms, preferably a $C_1$ to $C_6$ alkanediyl, which may be interrupted by 1 or two O atoms, or
(b) a divalent group $-D^{L11}-Ar^{L11}-D^{L11}-$;

$Z^{L2}$, $Z^{L3}$ are independently selected from a chemical bond and hydroxyethanediyl;
n is an integer of from 1 to 400;
m is 0 or an integer of from 1 to 400;
o is an integer of from 1 to 100; and
p, r are independetly 0 or 1.

**2.** The composition according to claim 1, wherein B and B' are the same or different, preferably the same, and are aminoacid fragments of formula L2a, wherein $D^{L1}$ is selected from (i) a linear $C_2$ to $C_{10}$ alkanediyl group, (ii) a $C_2$ to $C_3$ oxyalkylene group, (iii) a cyclic $C_6$ to $C_{12}$ alkanediyl group, or (iv) a divalent phenyl or pyridyl group.

**3.** The composition according to claim 1, wherein B and B' are the same or different, preferably the same, and are a fragment of formula L2b, wherein (a) $D^{L11}$ and $D^{L12}$ are independently selected from a linear or branched $C_1$ to $C_4$ alkanediyl or (b) $D^{L11}$ and $D^{L12}$, together with the two adjacent N atoms, form an imidazole ring.

**4.** The composition according to anyone of claims claim 1 to 3, wherein A is a fragment of formula L3a, wherein $D^{L2}$ is selected from methanediyl, ethanediyl, and 1,3-propanediyl.

**5.** The composition according to anyone of claims claim 1 to 3, wherein A is a fragment of formula L3a, wherein $D^{L2}$ is selected from an ether or polyether group of formula L2a

$$-(D^{L10}-O-]_o D^{L10}- \qquad (L2a)$$

wherein $D^{L10}$ is selected from a $C_1$-$C_4$-alkanediyl and o is an integer from 1 to 50.

**6.** The composition according to anyone of claims 1 to 3, wherein A is a fragment of formula L3b, wherein $D^{L21}$, $D^{L22}$, and $D^{L23}$ are independently selected from methanediyl, ethanediyl, and propanediyl.

**7.** The composition according to anyone of claims 1 to 3, wherein A is a fragment of formula L3b, wherein $D^{L21}$ and $D^{L22}$, together with the two adjacent N atoms, form an imidazole ring and $D^{L23}$ is selected from methanediyl, ethanediyl, propanediyl and butanediyl.

**8.** The composition according to anyone of the preceding claims, wherein Z is selected from $C_1$ to $C_{12}$ alkanediyl, a bis(2-ethanediyl)ether group, 2-hydroxypropane-1,3-diyl, and 4,4'-bis(methyl)biphenyl.

**9.** The composition according to anyone of the preceding claims, wherein n is an integer from 2 to 200, preferably an integer from 2 to 150.

**10.** The composition according to anyone of the preceding claims, wherein m is 0 or an integer from 1 to 200, preferably 0 or an integer from 2 to 150.

**11.** The composition according to anyone of the preceding claims, wherein the mass average molecular weight $M_w$ of the polyaminoamide is of from 450 g/mol to 150 000 g/mol, preferably from 1000 g/mol to 50 000 g/mol.

**12.** The composition according to anyone of the preceding claims, further comprising one or more accelerating agents, one or more suppressing agents, or a combination thereof.

**13.** Use of the copper electroplating composition according to anyone of the preceding claims for depositing copper on a substrate comprising a recessed feature comprising a conductive feature bottom and a dielectric feature side wall, wherein the recessed feature has an aperture size from 500 nm to 500 μm.

**14.** A process for electrodepositing copper on a substrate comprising a recessed feature comprising a conductive feature bottom and a dielectric feature side wall, the process comprising:

a) contacting a composition according to anyone of claims 1 to 12 with the substrate, and
b) applying a current to the substrate for a time sufficient to deposit a copper layer into the recessed feature,

wherein the recessed feature has an aperture size from 500 nm to 500 μm.

**15.** The process according to claims 14, wherein the aperture size is from 1 μm to 200 μm.

**Patentansprüche**

**1.** Zusammensetzung für die galvanische Abscheidung von Kupfer, umfassend Kupferionen, eine Säure und mindestens ein Polyaminoamid mit einer Gruppe der Formel L1

$$[B\text{-}A\text{-}B'\text{-}Z]_n[Y\text{-}Z]_m \qquad (L1)$$

wobei

B, B' gleich oder verschieden, vorzugsweise gleich, sind und für Aminosäurefragmente der Formel L2a

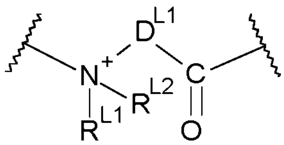

(L2a)

oder der Formel L2b

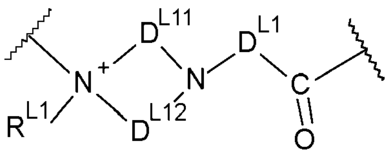

(L2b)

stehen,
A für ein Diaminfragment steht, das unabhängig ausgewählt ist aus Formel L3a

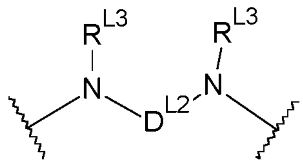

(L3a)

oder Formel L3b

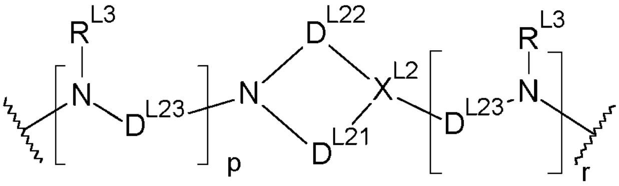

(L3b)

$D^{L1}$ ausgewählt ist aus einer zweiwertigen Gruppe, die ausgewählt ist aus

(a) einem $C_1$-$C_{20}$-Alkandiyl, das gegebenenfalls durch eine Aminogruppe substituiert oder durch eine Doppelbindung oder eine Iminogruppe unterbrochen sein kann,
(b) einer Ether- oder Polyethergruppe der Formel L2a

$$-(D^{L10}\text{-O-}]_o D^{L10}- \qquad \text{(L2c)}$$

$D^{L2}$ für eine zweiwertige Gruppe steht, die ausgewählt ist aus

(a) einem linearen, verzweigten oder cyclischen $C_1$- bis $C_{20}$-Alkandiyl, das gegebenenfalls durch ein oder mehrere $NR^{L10}$ unterbrochen oder durch eine oder mehrere, vorzugsweise 1 oder 2, Gruppen $NR^{L10}R^{L11}$ oder $OR^{L10}$ substituiert sein kann, oder
(b) $-D^{L13}-Ar^{L13}-D^{L13}$; oder
(c) einer Ether- oder Polyethergruppe der Formel L2c $D^{L10}$ aus einem linearen oder verzweigten $C_1$-$C_6$-Alkandiyl, vorzugsweise Ethandiyl oder Propandiyl, ausgewählt ist;

$D^{L13}$ aus einem $C_1$-$C_6$-Alkandiyl, vorzugsweise Methandiyl oder Ethandiyl, ausgewählt ist;
$Ar^{L13}$ für eine aromatische $C_6$- bis $C_{10}$-Gruppierung, vorzugsweise p-Phenylen, steht;
$D^{L11}$, $D^{L12}$

(a) unabhängig aus einem linearen oder verzweigten $C_1$- bis $C_6$-Alkandiyl ausgewählt sind oder
(b) beide zusammen mit den benachbarten beiden N-Atomen Teil eines 5- oder 6-gliedrigen aromatischen heterocyclischen Ringsystems sind;

$D^{L21}$, $D^{L22}$

(a) unabhängig aus einem linearen oder verzweigten $C_1$- bis $C_6$-Alkandiyl ausgewählt sind oder
(b) beide zusammen mit den benachbarten beiden N-Atomen Teil eines 5- oder 6-gliedrigen aromatischen heterocyclischen Ringsystems sind;

$D^{L23}$ für ein $C_1$- bis $C_6$-Alkandiyl steht;
$R^{L1}$, $R^{L2}$ unabhängig aus einem $C_1$- bis $C_6$-Alkyl ausgewählt sind;
$R^{L3}$ aus H und einem $C_1$- bis $C_6$-Alkyl ausgewählt ist;
$X^{L2}$ für N oder $CR^{L3}$ steht;
Y für ein Comonomerfragment steht;
Z für ein zweiwertiges Kupplungsfragment der Formel L4 steht

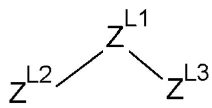

(L4)

$Z^{L1}$ ausgewählt ist aus

(a) einem linearen oder verzweigten $C_1$- bis $C_{12}$-Alkandiyl, das durch ein oder mehrere O-Atome unterbrochen sein kann, vorzugsweise ein $C_1$- bis $C_6$-Alkandiyl, das durch 1 oder zwei O-Atome unterbrochen sein kann, oder
(b) einer zweiwertigen Gruppe $-D^{L11}-Ar^{L11}-D^{L11}-$;

$Z^{L2}$, $Z^{L3}$ unabhängig aus einer chemischen Bindung und Hydroxyethandiyl ausgewählt sind;
n für eine Zahl von 1 bis 400 steht;
m für 0 oder eine ganze Zahl von 1 bis 400 steht;
o für eine ganze Zahl von 1 bis 100 steht; und
p, r unabhängig für 0 oder 1 stehen.

**2.** Zusammensetzung nach Anspruch 1, wobei B und B' gleich oder verschieden, vorzugsweise gleich, sind und für Aminosäurefragmente der Formel L2a stehen, wobei $D^{L1}$ aus (i) einer linearen $C_2$-bis $C_{10}$-Alkandiylgruppe, (ii) einer $C_2$- bis $C_3$-Oxyalkylengruppe, (iii) einer cyclischen $C_6$- bis $C_{12}$-Alkandiylgruppe oder (iv) einer zweiwertigen Phenyl- oder Pyridylgruppe ausgewählt ist.

**3.** Zusammensetzung nach Anspruch 1, wobei B und B' gleich oder verschieden, vorzugsweise gleich, sind und für ein Fragment der Formel L2b stehen, wobei (a) $D^{L11}$ und $D^{L12}$ unabhängig aus einem linearen oder verzweigten $C_1$- bis $C_4$-Alkandiyl ausgewählt sind oder (b) $D^{L11}$ und $D^{L12}$ zusammen mit den zwei benachbarten N-Atomen einen Imidazolring bilden.

**4.** Zusammensetzung nach einem der Ansprüche 1 bis 3, wobei A für ein Fragment der Formel L3a steht, wobei $D^{L2}$ aus Methandiyl, Ethandiyl und 1,3-Propandiyl ausgewählt ist.

**5.** Zusammensetzung nach einem der Ansprüche 1 bis 3, wobei A für ein Fragment der Formel L3a steht, wobei $D^{L2}$ aus einer Ether- oder Polyethergruppe der Formel L2a ausgewählt ist

$$-(D^{L10}-O-]_o D^{L10}- \qquad (L2a)$$

wobei $D^{L10}$ aus einem $C_1$-$C_4$-Alkandiyl ausgewählt ist und o für eine ganze Zahl von 1 bis 50 steht.

**6.** Zusammensetzung nach einem der Ansprüche 1 bis 3, wobei A für ein Fragment der Formel L3b steht, wobei $D^{L21}$, $D^{L22}$ und $D^{L23}$ unabhängig aus Methandiyl, Ethandiyl und Propandiyl ausgewählt sind.

**7.** Zusammensetzung nach einem der Ansprüche 1 bis 3, wobei A für ein Fragment der Formel L3b steht, wobei $D^{L21}$ und $D^{L22}$ zusammen mit den zwei benachbarten N-Atomen einen Imidazolring bilden und $D^{L23}$ aus Methandiyl, Ethandiyl, Propandiyl und Butandiyl ausgewählt ist.

**8.** Zusammensetzung nach einem der vorhergehenden Ansprüche, wobei Z aus $C_1$- bis $C_{12}$-Alkandiyl, einer Bis(2-ethandiyl)ethergruppe, 2-Hydroxypropan-1,3-diyl und 4,4'-Bis(methyl)biphenyl ausgewählt ist.

**9.** Zusammensetzung nach einem der vorhergehenden Ansprüche, wobei n für eine ganze Zahl von 2 bis 200, vorzugsweise eine ganze Zahl von 2 bis 150, steht.

**10.** Zusammensetzung nach einem der vorhergehenden Ansprüche, wobei m für 0 oder eine ganze Zahl von 1 bis 200, vorzugsweise 0 oder eine ganze Zahl von 2 bis 150, steht.

**11.** Zusammensetzung nach einem der vorhergehenden Ansprüche, wobei das massenmittlere Molekulargewicht $M_w$ des Polyaminoamids 450 g/mol bis 150.000 g/mol, vorzugsweise 1000 g/mol bis 50.000 g/mol, beträgt.

**12.** Zusammensetzung nach einem der vorhergehenden Ansprüche, ferner umfassend ein oder mehrere Beschleunigungsmittel, ein oder mehrere Unterdrückungsmittel oder eine Kombination davon.

**13.** Verwendung der Zusammensetzung zur galvanischen Abscheidung von Kupfer nach einem der vorhergehenden Ansprüche zum Abscheiden von Kupfer auf einem Substrat mit einem versenkten Strukturmerkmal, das einen leitfähigen Strukturmerkmalboden und eine dielektrische Strukturmerkmalseitenwand umfasst, wobei das versenkte Strukturmerkmal eine Aperturgröße von 500 nm bis 500 μm aufweist.

**14.** Verfahren zur galvanischen Abscheidung von Kupfer auf einem Substrat mit einem versenkten Strukturmerkmal, das einen leitfähigen Strukturmerkmalboden und eine dielektrische Strukturmerkmalseitenwand umfasst, wobei das Verfahren Folgendes umfasst:

a) Inkontaktbringen einer Zusammensetzung nach einem der Ansprüche 1 bis 12 mit dem Substrat und
b) Anlegen eines Stroms an das Substrat über einen Zeitraum, der zur Abscheidung einer Kupferschicht in dem versenkten Strukturmerkmal ausreicht,

wobei das versenkte Strukturmerkmal eine Aperturgröße von 500 nm bis 500 μm aufweist.

**15.** Verfahren nach Anspruch 14, wobei die Aperturgröße 1 μm bis 200 μm beträgt.

## Revendications

**1.** Composition d'électroplacage de cuivre comprenant des ions cuivre, un acide, et au moins un polyaminoamide comprenant un groupe de formule L1

$$[B\text{-}A\text{-}B'\text{-}Z]_n[Y\text{-}Z]_m \qquad (L1)$$

avec

B, B' étant identiques ou différents, de préférence identiques, et étant des fragments d'acide aminé de formule L2a

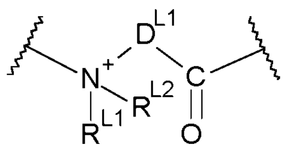

(L2a)

ou de formule (L2b)

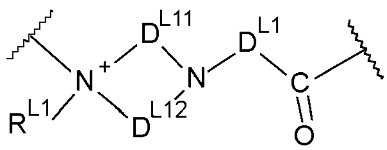

(L2b)

A étant un fragment diamine choisi indépendamment parmi la formule L3a

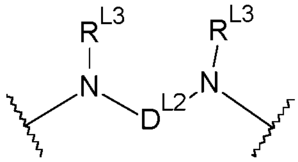

(L3a)

ou la formule (L3b)

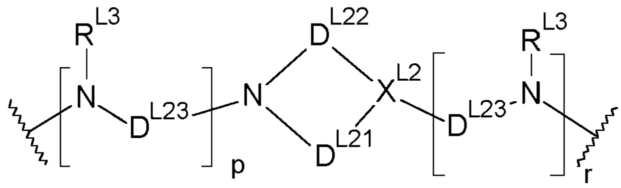

(L3b)

$D^{L1}$ étant un groupe divalent choisi parmi

(a) un alcanediyle en $C_1$-$C_{20}$, qui peut être éventuellement substitué par un groupe amino ou interrompu par une double liaison ou un groupe imino,
(b) un groupe éther ou polyéther de formule L2a

$$-(D^{L10}\text{-O-}]_o D^{L10}\text{-} \qquad (L2c)$$

$D^{L2}$ étant un groupe divalent choisi parmi

(a) un alcanediyle en $C_1$ à $C_{20}$ linéaire, ramifié ou cyclique, qui peut éventuellement être interrompu par un ou plusieurs $NR^{L10}$, ou substitué par un ou plusieurs, de préférence 1 ou 2 groupes $NR^{L10}R^{L11}$ ou $OR^{L10}$, ou
(b) $-D^{L13}\text{-}Ar^{L13}\text{-}D^{L13}\text{-}$ ; ou
(c) un groupe éther ou polyéther de formule L2c

$D^{L10}$ étant choisi parmi un alcanediyle en $C_1$-$C_6$ linéaire ou ramifié, de préférence l'éthanediyle ou le propanediyle ;
$D^{L13}$ étant choisi parmi un alcanediyle en $C_1$-$C_6$, de préférence le méthanediyle ou l'éthanediyle ;
$Ar^{L13}$ étant un groupement aromatique en $C_6$ à $C_{10}$ , de préférence le p-phénylène ;
$D^{L11}$, $D^{L12}$ étant

(a) indépendamment choisis parmi un alcanediyle en $C_1$ à $C_6$ linéaire ou ramifié, ou
(b) tous deux, ensemble avec les deux atomes N adjacents, faisant partie d'un système de cycle hétérocyclique aromatique à 5 ou 6 chaînons ;

$D^{L21}$, $D^{L22}$ étant

(a) indépendamment choisis parmi un alcanediyle en $C_1$ à $C_6$ linéaire ou ramifié, ou
(b) tous deux, ensemble avec les deux atomes N adjacents, faisant partie d'un système de cycle hétérocyclique aromatique à 5 ou 6 chaînons ;

$D^{L23}$ étant un alcanediyle en $C_1$ à $C_6$ ;
$R^{L1}$, $R^{L2}$ étant indépendamment choisis parmi un alkyle en $C_1$ à $C_6$ ;
$R^{L3}$ étant choisi parmi H et un alkyle en $C_1$ à $C_6$ ;
$X^{L2}$ étant N ou $CR^{L3}$ ;
Y étant un fragment de co-monomère ;
Z étant un fragment de couplage divalent de formule L4

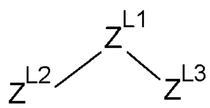

(L4)

$Z^{L1}$ étant choisi parmi

(a) un alcanediyle en $C_1$ à $C_{12}$ linéaire ou ramifié, qui peut être interrompu par un ou plusieurs atomes O, de préférence un alcanediyle en $C_1$ à $C_6$ , qui peut être interrompu par 1 ou deux atomes O, ou
(b) un groupe divalent $-D^{L11}\text{-}Ar^{L11}\text{-}D^{L11}\text{-}$ ;

$Z^{L2}$, $Z^{L3}$ étant indépendamment choisis parmi une liaison chimique et l'hydroxyéthanediyle ;

n étant un entier allant de 1 à 400 ;
m étant 0 ou un entier allant de 1 à 400 ;
o étant un entier allant de 1 à 100 ; et
p, r étant indépendamment 0 ou 1.

**2.** Composition selon la revendication 1, B et B' étant identiques ou différents, de préférence identiques, et étant des fragments d'acide aminé de formule L2a, $D^{L1}$ étant choisi parmi (i) un groupe alcanediyle en $C_2$ à $C_{10}$ linéaire, (ii) un groupe oxyalkylène en $C_2$ à $C_3$, (iii) un groupe alcanediyle en $C_6$ à $C_{12}$ cyclique ou (iv) un groupe phényle ou pyridinyle divalent.

**3.** Composition selon la revendication 1, B et B' étant identiques ou différents, de préférence identiques, et étant un fragment de formule L2b, (a) $D^{L11}$ et $D^{L12}$ étant indépendamment choisis parmi un alcanediyle en $C_1$ à $C_4$ linéaire ou ramifié ou (b) $D^{L11}$ et $D^{L12}$, ensemble avec les deux atomes N adjacents, formant un cycle imidazole.

**4.** Composition selon l'une quelconque des revendications 1 à 3, A étant un fragment de formule L3a, $D^{L2}$ étant choisi parmi le méthanediyle, l'éthanediyle ou le 1,3-propanediyle.

**5.** Composition selon l'une quelconque des revendications 1 à 3, A étant un fragment de formule L3a, $D^{L2}$ étant choisi parmi un groupe éther ou polyéther de formule L2a

$$-(D^{L10}\text{-O-}]_o D^{L10}- \qquad (L2a)$$

$D^{L10}$ étant choisi parmi un alcanediyle en $C_1$-$C_4$ et o étant un entier de 1 à 50.

**6.** Composition selon l'une quelconque des revendications 1 à 3, A étant un fragment de formule L3b, $D^{L21}$, $D^{L22}$ et $D^{L23}$ étant indépendamment choisis parmi le méthanediyle, l'éthanediyle et le propanediyle.

**7.** Composition selon l'une quelconque des revendications 1 à 3, A étant un fragment de formule L3b, $D^{L21}$ et $D^{L22}$, ensemble avec les deux atomes N adjacents formant un cycle imidazole et $D^{L23}$ étant choisi parmi le méthanediyle, l'éthanediyle, le propanediyle et le butanediyle.

**8.** Composition selon l'une quelconque des revendications précédentes, Z étant choisi parmi un alcanediyle en $C_1$ à $C_{12}$, un groupe bis (2-éthanediyl) éther, le 2-hydroxypropane-1,3-diyle et le 4,4'-bis(méthyl)biphényle.

**9.** Composition selon l'une quelconque des revendications précédentes, n étant un entier de 2 à 200, de préférence un entier de 2 à 150.

**10.** Composition selon l'une quelconque des revendications précédentes, m étant 0 ou un entier de 1 à 200, de préférence 0 ou un entier de 2 à 150.

**11.** Composition selon l'une quelconque des revendications précédentes, le poids moléculaire moyen en masse $M_w$ du polyaminoamide étant de 450 g/mole à 150 000 g/mole, de préférence de 1 000 g/mole à 50 000 g/mole.

**12.** Composition selon l'une quelconque des revendications précédentes, comprenant en outre un ou plusieurs agents d'accélération, un ou plusieurs agents de suppression ou une combinaison de ceux-ci.

**13.** Utilisation de la composition d'électroplacage de cuivre selon l'une quelconque des revendications précédentes pour le dépôt de cuivre sur un substrat comprenant un renfoncement comprenant un fond conducteur et une paroi latérale diélectrique, le renfoncement ayant une taille d'ouverture de 500 nm à 500 $\mu$m.

**14.** Procédé pour l'électrodéposition de cuivre sur un substrat comprenant un renfoncement comprenant un fond conducteur et une paroi latérale diélectrique, le procédé comprenant :

a) la mise en contact d'une composition selon l'une quelconque des revendications 1 à 12 avec le substrat, et
b) l'application d'un courant au substrat pendant un temps suffisant pour déposer une couche de cuivre dans le renfoncement,

le renfoncement ayant une taille d'ouverture de 500 nm à 500 $\mu$m.

**15.** Procédé selon la revendication 14, la taille d'ouverture étant de 1 μm à 200 μm.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2012292193 A
- US 2014097092 A
- WO 2014072885 A
- US 6425996 B1
- US 20160076160 A1
- EP 2021057522 W
- US 5435898 A
- WO 2010115796 A
- WO 2010115756 A
- WO 2010115757 A
- WO 2010115717 A
- WO 2011012462 A
- WO 2011012475 A
- WO 2018073011 A
- WO 2018114985 A
- WO 2011151785 A1
- WO 2011064154 A2
- WO 2014072885 A2
- WO 2010069810 A
- WO 2012085811 A1
- WO 2018219848 A
- WO 2016020216 A